# FASCICULE DE BREVET EUROPEEN

(11) **EP 3 479 408 B1**
(45) Date de publication et mention de la délivrance du brevet: **05.08.2020**
(21) Numéro de dépôt: 17740058.7
(22) Date de dépôt: 22.06.2017
(51) Int. Cl.: H01L 27/15, H01L 33/00, H01L 33/18, H01L 33/24, H01L 33/38, H01L 33/54, H01L 33/60, H01L 33/62, H01L 33/08, H01L 33/42, H01L 33/50, H01L 33/64

(54) **DISPOSITIF OPTOÉLECTRONIQUE À PIXELS À CONTRASTE ET LUMINANCE AMÉLIORÉS**
OPTOELEKTRONISCHE VORRICHTUNG MIT PIXELN MIT VERBESSERTEM KONTRAST UND VERBESSERTER HELLIGKEIT
OPTOELECTRONIC DEVICE WITH PIXELS OF IMPROVED CONTRAST AND BRIGHTNESS

(30) Priorité: 30.06.2016 FR 1656170
(43) Date de publication de la demande: 08.05.2019
(73) Titulaire: Aledia, 38040 Grenoble (FR)
(72) Inventeur: DUPONT, Tiphaine, 38000 Grenoble (FR); SCARINGELLA, Sylvia, 8330 Montbonnot Saint Martin (FR); DORNEL, Erwan, 38800 Champagnier (FR); GIBERT, Philippe, 38960 St Etienne De Crossey (FR); GILET, Philippe, 38470 Teche (FR); HUGON, Xavier, 38470 Teche (FR); GOUTAUDIER, Fabienne, 38000 Grenoble (FR)
(74) Mandataire: Cabinet Beaumont
(86) Numéro de dépôt international: PCT/FR2017/051671
(87) Numéro de publication internationale: WO 2018/002485

(56) Documents cités:
- WO-A1-03/012884
- WO-A1-2016/001200
- WO-A1-2016/108021
- CN-A- 101 383 341
- FR-A- 1 359 413
- FR-A1- 3 011 383
- US-A1- 2011 126 891

## Description

La présente demande de brevet revendique la priorité de la demande de brevet français FR16/56170.

### Domaine

La présente demande concerne un dispositif optoélectronique à diodes électroluminescentes, notamment à diodes électroluminescentes en matériaux inorganiques, par exemple un écran d'affichage ou un dispositif de projection d'images.

### Exposé de l'art antérieur

Il existe des dispositifs optoélectroniques, notamment des écrans d'affichage ou des dispositifs de projection, comprenant des diodes électroluminescentes à base de matériaux semiconducteurs comprenant un empilement de couches semiconductrices comportant majoritairement au moins un élément du groupe III et un élément du groupe V, appelé par la suite composé III-V, notamment le nitrure de gallium (GaN), le nitrure de gallium et d'indium (GaInN) et le nitrure de gallium et d'aluminium (GaAlN).

Un pixel d'une image correspond à l'élément unitaire de l'image affichée par un écran d'affichage ou projetée par un dispositif de projection. Lorsque le dispositif optoélectronique est un écran d'affichage d'images monochromes ou un dispositif de projection d'images monochromes, il comprend en général une seule source lumineuse, ou pixel d'affichage, pour l'affichage de chaque pixel de l'image. Lorsque le dispositif optoélectronique est un écran d'affichage d'images couleur ou un dispositif de projection d'images couleur, il comprend en général pour l'affichage de chaque pixel d'image au moins trois composants d'émission et/ou de régulation de l'intensité lumineuse, également appelés sous-pixels d'affichage, qui émettent chacun un rayonnement lumineux sensiblement dans une seule couleur (par exemple, le rouge, le vert et le bleu). La superposition des rayonnements émis par ces trois sous-pixels d'affichage fournit à l'observateur la sensation colorée correspondant au pixel de l'image affichée. On appelle dans ce cas pixel d'affichage de l'écran d'affichage ou du dispositif de projection l'ensemble formé par les trois sous-pixels d'affichage utilisés pour l'affichage d'un pixel d'image.

Il est connu de réaliser des dispositifs optoélectroniques à diodes électroluminescentes formées à partir d'éléments semiconducteurs tridimensionnels, par exemple des microfils, des nanofils, des éléments coniques ou des éléments tronconiques. Les diodes électroluminescentes sont alors dites tridimensionnelles. Un tel dispositif optoélectronique est connu de la demande de brevet WO 2016/001200 A1.

La demande de brevet WO 2016/108021 A1 décrit des dispositifs optoélectroniques à diodes électroluminescentes tridimensionnelles, notamment des écrans d'affichage ou des dispositifs de projection, comprenant des pixels d'affichage. L'utilisation de diodes électroluminescentes tridimensionnelles permet d'augmenter l'intensité lumineuse maximale pouvant être émise par chaque sous-pixel d'affichage par rapport à une diode électroluminescente obtenue par empilement de couches semiconductrices planes.

De nombreuses contraintes doivent être prises en compte lors de la conception d'un dispositif optoélectronique à pixels d'affichage, à savoir :
la luminance, définie comme le quotient de l'intensité lumineuse de la surface lumineuse du dispositif optoélectronique par l'aire de cette surface projetée sur la perpendiculaire à la direction d'observation, doit être la plus élevée possible ;
le contraste, défini comme le rapport d'intensité lumineuse entre un point blanc extrême et un point noir extrême, doit être le plus élevé possible ; et
la chaleur produite par les diodes électroluminescentes doit être évacuée efficacement.

Il peut être difficile de satisfaire toutes ces contraintes lorsque les pixels d'affichage comprennent des diodes électroluminescentes tridimensionnelles.

### Résumé

Un objet d'un mode de réalisation est de pallier tout ou partie des inconvénients des dispositifs optoélectroniques à diodes électroluminescentes tridimensionnelles comprenant des pixels d'affichage décrits précédemment, notamment des écrans d'affichage ou des dispositifs de projection.

Un autre objet d'un mode de réalisation est d'augmenter la luminance du dispositif optoélectronique.

Un autre objet d'un mode de réalisation est d'augmenter le contraste du dispositif optoélectronique.

Un autre objet d'un mode de réalisation est d'augmenter l'évacuation de la chaleur produite par les sources lumineuses du dispositif optoélectronique.

Ainsi, un mode de réalisation prévoit un dispositif optoélectronique comprenant un substrat comprenant des première et deuxième faces opposées, des éléments d'isolation électrique latérale s'étendant de la première face à la deuxième face et délimitant dans le substrat des premières portions semiconductrices ou conductrices isolées électriquement les unes des autres, le dispositif optoélectronique comprenant, en outre, pour chaque première portion, un ensemble de diodes électroluminescentes reposant sur la première face et reliées électriquement à la première portion, le dispositif optoélectronique comprenant, en outre, une couche d'électrode conductrice et au moins partiellement transparente recouvrant toutes les diodes électroluminescentes, une couche de protection contenant un premier matériau diélectrique et au moins partiellement transparent au moins dans la gamme de longueur d'onde d'émission des diodes électroluminescentes et d'éventuels luminophores présents dans la couche de protection recouvrant la couche d'électrode, et des murs s'étendant au moins en partie dans la couche de protection et délimitant dans la couche de protection des deuxièmes portions entourant ou en vis-à-vis des ensembles de diodes électroluminescentes, les murs contenant au moins un deuxième matériau différent du premier matériau et compris dans le groupe comprenant l'air, un métal, un matériau semiconducteur, un alliage métallique, un matériau partiellement transparent au moins dans la gamme de longueur d'onde d'émission des diodes électroluminescentes et des éventuels luminophores, et un coeur en un matériau au moins partiellement transparent au moins dans la gamme de longueur d'onde d'émission des diodes électroluminescentes et des éventuels luminophores recouvert d'une couche opaque ou réfléchissante au moins dans la gamme de longueur d'onde d'émission des diodes électroluminescentes et des éventuels luminophores.

Selon la présente invention, chaque diode électroluminescente comprend au moins un élément semiconducteur filaire, conique ou tronconique, intégrant ou recouvert au sommet et/ou au moins sur une partie de ses faces latérales par une coque comprenant au moins une couche active adaptée à fournir la majorité du rayonnement de la diode électroluminescente.

Selon un mode de réalisation, la couche de protection entoure chaque diode électroluminescente.

Selon un mode de réalisation, la couche de protection n'entoure pas les diodes électroluminescentes.

Selon un mode de réalisation, les murs s'étendent au moins sur la totalité de l'épaisseur de la couche de protection.

Selon un mode de réalisation, au moins l'un des murs comprend un bloc solide se prolongeant par une ouverture remplie d'air.

Selon un mode de réalisation, la couche de protection comprend des luminophores.

Selon un mode de réalisation, la couche de protection comprend un cristal monocristallin d'un luminophore.

Selon un mode de réalisation, le dispositif optoélectronique comprend, en outre, une plaque d'un matériau au moins en partie transparent au moins dans la gamme de longueur d'onde d'émission des diodes électroluminescentes et des éventuels luminophores recouvrant la couche de protection et reliée mécaniquement au substrat.

Selon un mode de réalisation, la plaque est séparée de la couche de protection par un film d'air ou de vide partiel.

Selon un mode de réalisation, le dispositif optoélectronique comprend, en outre, des murs supplémentaires dont la hauteur est supérieure à l'épaisseur de la couche de protection au contact de la plaque et reposant sur le substrat.

Selon un mode de réalisation, le dispositif optoélectronique comprend, en outre, une couche conductrice recouvrant la couche d'électrode autour des diodes électroluminescentes de chaque ensemble.

Selon un mode de réalisation, le substrat est en silicium, en germanium, en carbure de silicium, en un composé III-V, tel que du GaN ou du GaAs, ou en ZnO.

Selon un mode de réalisation, chaque élément semiconducteur est majoritairement en un composé III-V, notamment du nitrure de gallium, ou en un composé II-VI.

Selon un mode de réalisation, le dispositif optoélectronique est un écran d'affichage ou un dispositif de projection.

Selon un mode de réalisation, le dispositif optoélectronique comprend, en outre, sur la couche d'encapsulation des filtres adaptés à absorber et/ou réfléchir au moins en partie le rayonnement émis par les diodes électroluminescentes.

Selon un mode de réalisation, le dispositif optoélectronique comprend, en outre, sur la plaque des filtres adaptés à absorber et/ou réfléchir au moins en partie le rayonnement émis par les diodes électroluminescentes.

Selon un mode de réalisation, les murs correspondent à des portions du substrat.

Un mode de réalisation prévoit également un procédé de fabrication d'un dispositif optoélectronique comprenant les étapes suivantes :
a) former, dans un substrat comprenant des première et deuxième faces opposées, des éléments d'isolation électrique latérale s'étendant de la première face à la deuxième face et délimitant dans le substrat des premières portions semiconductrices ou conductrices isolées électriquement les unes des autres ;
b) former, pour chaque première portion, un ensemble de diodes électroluminescentes reposant sur la première face et reliées électriquement à la première portion ;
c) former, pour chaque première portion, une couche d'électrode conductrice et au moins partiellement transparente recouvrant toutes les diodes électroluminescentes ;
d) former une couche de protection d'un premier matériau diélectrique et au moins partiellement transparent au moins dans la gamme de longueur d'onde d'émission des diodes électroluminescentes et d'éventuels luminophores présents dans la couche de protection recouvrant la couche d'électrode, et des murs s'étendant au moins en partie dans la couche de protection et délimitant dans la couche de protection des deuxièmes portions entourant ou en vis-à-vis des ensembles de diodes électroluminescentes, les murs contenant au moins un deuxième matériau différent du premier matériau et compris dans le groupe comprenant l'air, un métal, un matériau semiconducteur, un alliage métallique, un matériau partiellement transparent au moins dans la gamme de longueur d'onde d'émission des diodes électroluminescentes et des éventuels luminophores et un coeur en un matériau au moins partiellement transparent au moins dans la gamme de longueur d'onde d'émission des diodes électroluminescentes et des éventuels luminophores recouvert d'une couche opaque ou réfléchissante au moins dans la gamme de longueur d'onde d'émission des diodes électroluminescentes et des éventuels luminophores.

Selon la présente invention, chaque diode électroluminescente comprend au moins un élément semiconducteur filaire, conique ou tronconique, intégrant ou recouvert au sommet et/ou au moins sur une partie de ses faces latérales par une coque comprenant au moins une couche active adaptée à fournir la majorité du rayonnement de la diode électroluminescente.

Selon un mode de réalisation, la couche de protection entoure chaque diode électroluminescente.

Selon un mode de réalisation, la couche de protection n'entoure pas les diodes électroluminescentes.

Selon un mode de réalisation, les murs s'étendent au moins sur la totalité de l'épaisseur de la couche de protection.

Selon un mode de réalisation, au moins l'un des murs comprend un bloc solide se prolongeant par une ouverture remplie d'air.

Selon un mode de réalisation, la couche de protection comprend des luminophores.

Selon un mode de réalisation, la couche de protection comprend un cristal monocristallin d'un luminophore.

Selon un mode de réalisation, le procédé comprend, en outre, la liaison mécanique au substrat d'une plaque d'un matériau au moins en partie transparent au moins dans la gamme de longueur d'onde d'émission des diodes électroluminescentes et des éventuels luminophores et recouvrant la couche de protection.

Selon un mode de réalisation, la plaque est séparée de la couche de protection par un film d'air ou de vide partiel.

Selon un mode de réalisation, le procédé comprend, en outre, la formation de murs supplémentaires dont la hauteur est supérieure à l'épaisseur de la couche de protection au contact de la plaque et reposant sur le substrat.

Selon un mode de réalisation, le procédé comprend, en outre, la formation d'une couche conductrice recouvrant la couche d'électrode autour des diodes électroluminescentes de chaque ensemble.

Selon un mode de réalisation, le substrat est en silicium, en germanium, en carbure de silicium, en un composé III-V, tel que du GaN ou du GaAs, ou en ZnO.

Selon un mode de réalisation, chaque élément semiconducteur est majoritairement en un composé III-V, notamment du nitrure de gallium, ou en un composé II-VI.

Selon un mode de réalisation, le dispositif optoélectronique est un écran d'affichage ou un dispositif de projection.

Selon un mode de réalisation, le procédé comprend, en outre, la formation sur la couche d'encapsulation de filtres adaptés à absorber et/ou réfléchir au moins en partie le rayonnement émis par les diodes électroluminescentes.

Selon un mode de réalisation, le procédé comprend, en outre, la formation sur la plaque de filtres adaptés à absorber et/ou réfléchir au moins en partie le rayonnement émis par les diodes électroluminescentes.

Selon un mode de réalisation, les murs correspondent à des portions du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B et 1C sont respectivement une vue de dessus, une vue de face avec coupe et une vue de dessous, partielles et schématiques, d'un mode de réalisation d'un dispositif optoélectronique à diodes électroluminescentes ;
les figures 2A à 2C, 3A et 3B, 4A à 4E et 5A à 5D illustrent les structures obtenues à des étapes successives de modes de réalisation d'un procédé de fabrication du dispositif optoélectronique représenté sur les figures 1A à 1C ;
les figures 6 à 25 sont des vues analogues à la figure 1B d'autres modes de réalisation d'un dispositif optoélectronique à diodes électroluminescentes ; et
les figures 26A à 26D illustrent les structures obtenues à des étapes successives d'un mode de réalisation d'un procédé de fabrication du dispositif optoélectronique représenté sur la figure 23.

### Description détaillée

Par souci de clarté, de mêmes éléments ont été désignés par de mêmes références aux différentes figures et, de plus, les diverses figures ne sont pas tracées à l'échelle. En outre, seuls les éléments utiles à la compréhension des modes de réalisation ont été représentés et sont décrits. En particulier, le dispositif de commande d'un dispositif optoélectronique à diodes électroluminescentes est connu de l'homme de l'art et n'est pas décrit par la suite. Dans la suite de la description, sauf indication contraire, les termes "sensiblement", "environ" et "de l'ordre de" signifient "à 10 % près".

Les modes de réalisation décrits par la suite concernent des dispositifs optoélectroniques, notamment des écrans d'affichage ou des dispositifs de projection, comprenant des diodes électroluminescentes formées à partir d'éléments semiconducteurs tridimensionnels, par exemple des microfils, des nanofils, des éléments coniques ou des éléments tronconiques. Dans la suite de la description, des modes de réalisation sont décrits pour des diodes électroluminescentes formées à partir de microfils ou de nanofils. Toutefois, ces modes de réalisation peuvent être mis en oeuvre pour des éléments tridimensionnels autres que des microfils ou des nanofils, par exemple des éléments tridimensionnels en forme de pyramide.

En outre, dans la suite de la description, des modes de réalisation sont décrits pour des diodes électroluminescentes comprenant chacune une coque qui entoure au moins partiellement le microfil ou le nanofil. Toutefois, ces modes de réalisation peuvent être mis en oeuvre pour des diodes électroluminescentes pour lesquelles la zone active est située dans la hauteur ou au sommet du microfil ou du nanofil.

Le terme "microfil" ou "nanofil" désigne une structure tridimensionnelle de forme allongée selon une direction privilégiée dont au moins deux dimensions, appelées dimensions mineures, sont comprises entre 5 nm et 5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

Selon un mode de réalisation, il est prévu un dispositif optoélectronique, notamment un écran d'affichage ou un dispositif de projection, comprenant un circuit intégré comportant un substrat, par exemple un substrat conducteur ou semiconducteur, divisé en portions de substrat isolées électriquement les unes des autres et comportant, pour chaque sous-pixel d'affichage, des ensembles de diodes électroluminescentes formées sur la face avant du substrat. Chaque ensemble de diodes électroluminescentes comprend une diode électroluminescente ou plusieurs diodes électroluminescentes montées en parallèle. Par connexion de diodes électroluminescentes en parallèle, on entend que les anodes des diodes électroluminescentes sont connectées ensemble et que les cathodes des diodes électroluminescentes sont connectées ensemble. Chaque ensemble de diodes électroluminescentes élémentaires est équivalent à une diode électroluminescente globale comprenant une anode et une cathode. Le dispositif optoélectronique comprend, en outre, des moyens pour augmenter la luminance et/ou le contraste.

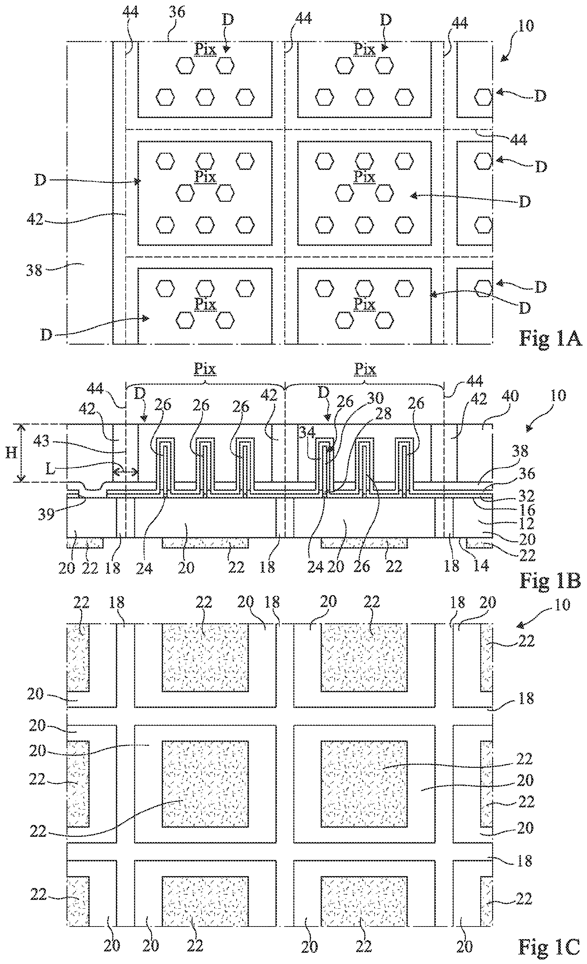

Les figures 1A à 1C représentent un mode de réalisation d'un dispositif optoélectronique 10, notamment un écran d'affichage ou un dispositif de projection, comprenant :
- un substrat conducteur ou semiconducteur 12 comprenant une face inférieure 14 et une face supérieure 16 opposée, la face supérieure 16 étant de préférence plane au moins au niveau des ensembles de diodes électroluminescentes ;
- des éléments 18 d'isolation électrique qui s'étendent dans le substrat 12 entre les faces 14 et 16 et qui divisent le substrat 12 en portions 20 conductrices ou semiconductrices ;
- des plots conducteurs électriquement 22 au contact de la face inférieure 14, chaque portion 20 étant au contact de l'un des plots conducteurs 22 ;
- des plots de germination 24 favorisant la croissance de fils, chaque plot de germination 24 étant au contact de la face 16 sur l'une des portions 20 conductrices ou semiconductrices, ces plots 24 pouvant être remplacés par une couche de germination couvrant la surface active de chaque pixel ;
- des fils 26, chaque fil 26 étant en contact avec l'un des plots de germination 24, chaque fil 26 comprenant une portion inférieure 28, en contact avec le plot de germination 24 et une portion supérieure 30, prolongeant la portion inférieure 28 ;
- une couche isolante 32 s'étendant sur la face 16 du substrat 12 et s'étendant sur les flancs latéraux de la portion inférieure 28 de chaque fil 26 ;
- une coque 34 comprenant un empilement de couches semiconductrices recouvrant la portion supérieure 30 de chaque fil 26 ;
- une couche 36 conductrice électriquement et au moins partiellement transparente dans la gamme de longueur d'onde d'émission des diodes électroluminescentes élémentaires formant une électrode recouvrant chaque coque 34, et s'étendant sur la couche isolante 32 entre les fils 26 ;
- une couche 38 conductrice électriquement recouvrant la couche d'électrode 36 entre les fils 26 mais ne s'étendant pas sur les fils 26 ou bien seulement sur une partie des flancs latéraux des fils 26, la couche conductrice 38 étant, en outre, au contact de l'une des portions semiconductrices 20 au travers d'une ouverture 39 prévue dans la couche d'électrode 36 et dans la couche isolante 32, ou, à titre de variante, la couche conductrice 38 étant, en outre, reliée électriquement à l'une des portions semiconductrices 20, par l'intermédiaire de la couche d'électrode 36 au travers de l'ouverture 39 prévue alors seulement dans la couche isolante 32 ;
- une couche d'encapsulation 40, également appelée couche de protection, au moins partiellement transparente dans la gamme de longueur d'onde d'émission des diodes électroluminescentes élémentaires et recouvrant l'ensemble de la structure et recouvrant, en particulier, complètement chaque fil 26, la couche d'encapsulation 40 n'étant, à titre de variante, pas présente ; et
- des murs 42 s'étendant dans la couche d'encapsulation 40 et entourant chaque ensemble D de fils 26 reposant sur chaque portion 20, les murs étant en un matériau différent de la couche d'encapsulation 40.

Selon un mode de réalisation, une couche isolante, appelée également couche de passivation, peut en outre être interposée entre la couche d'encapsulation 40 et la couche conductrice 38, entre la couche d'encapsulation 40 et les parties de la couche d'électrode 36 non recouvertes par la couche conductrice 38 et entre les murs 42 et la couche conductrice 38.

Chaque fil 26 et la coque 34 associée constituent une diode électroluminescente élémentaire. Les diodes électroluminescentes élémentaires situées sur une même portion semiconductrice 20 forment un ensemble D de diodes électroluminescentes. Chaque ensemble D comprend donc plusieurs diodes électroluminescentes élémentaires connectées en parallèle. Le nombre de diodes électroluminescentes élémentaires par ensemble D peut varier de 1 à plusieurs dizaines de milliers, typiquement de 25 à 1000. Le nombre de diodes électroluminescentes élémentaires par ensemble D peut varier d'un ensemble à l'autre. La couche d'électrode 36 et la couche d'encapsulation 40 sont au moins partiellement transparentes dans la gamme de longueur d'onde d'émission des diodes électroluminescentes élémentaires.

Chaque sous-pixel d'affichage Pix du dispositif optoélectronique 10 comprend l'une des portions 20 conductrices ou semiconductrices et l'ensemble D de diodes électroluminescentes reposant sur cette portion 20. Sur les figures 1A et 1B, on a représenté de façon schématique la séparation entre les sous-pixels d'affichage Pix par des lignes en traits pointillés 44. Selon un mode de réalisation, la surface occupée par chaque sous-pixel Pix en vue de dessus peut varier de 3 µm par 3 µm à environ 100000 µm² et typiquement de 25 µm² à 6 400 µm².

Chaque diode électroluminescente élémentaire est formée d'une coque recouvrant au moins partiellement un fil. La surface développée des couches actives des diodes électroluminescentes élémentaires d'un ensemble D est supérieure à la surface du sous-pixel d'affichage comprenant cet ensemble D. L'intensité maximale lumineuse pouvant être fournie par le sous-pixel d'affichage peut donc être supérieure à celle d'un sous-pixel d'affichage réalisé avec une technologie de diode électroluminescente inorganique bidimensionnelle.

Selon un mode de réalisation, le substrat 12 correspond à un substrat semiconducteur monolithique. Le substrat 12 semiconducteur est, par exemple, un substrat en silicium, en germanium, ou en un composé III-V tel que du GaAs. De préférence, le substrat 12 est un substrat de silicium monocristallin.

De préférence, le substrat semiconducteur 12 est dopé de façon à baisser la résistivité électrique jusqu'à une résistivité proche de celle des métaux, de préférence inférieure à quelques mohm.cm. Le substrat 12 est de préférence un substrat semiconducteur fortement dopé avec une concentration de dopants comprise entre 5*10¹⁶ atomes/cm³ et 2*10²⁰ atomes/cm³, de préférence entre 1*10¹⁹ atomes/cm³ et 2*10²⁰ atomes/cm³, par exemple 5*10¹⁹ atomes/cm³. Au début du procédé de fabrication du dispositif optoélectronique, le substrat 12 a une épaisseur comprise entre 275 µm et 1500 µm, de préférence 725 µm. Une fois que le dispositif optoélectronique est réalisé, après une étape d'amincissement décrite plus en détail par la suite, le substrat 12 a une épaisseur comprise entre 0 µm et 100 µm. Dans le cas d'un substrat 12 de silicium, des exemples de dopants de type P sont le bore (B) ou l'indium (In) et des exemples de dopants de type N sont le phosphore (P), l'arsenic (As), ou l'antimoine (Sb). De préférence, le substrat 12 est dopé de type N au phosphore. La face 14 du substrat 12 de silicium peut être une face (100) ou (111) .

Les plots de germination 24, appelés également îlots de germination, sont en un matériau favorisant la croissance des fils 26. Un traitement peut être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination. Le traitement peut comprendre la formation d'une région diélectrique sur les flancs latéraux des plots de germination et s'étendant sur et/ou dans le substrat et reliant, pour chaque paire de plots, l'un des plots de la paire à l'autre plot de la paire, les fils ne croissant pas sur la région diélectrique. Ladite région diélectrique peut déborder au-dessus des plots de germination 24. A titre de variante, les plots de germination 24 peuvent être remplacés, pour chaque sous-pixel, par une couche de germination recouvrant la face 16 du substrat 12, délimitant ainsi la surface active de chaque pixel et correspondant à une surface strictement inférieure à celle du pixel, chaque couche de germination ne s'étendant pas au-dessus des tranchées d'isolation 18. Une région diélectrique peut alors être formée au-dessus de la couche de germination pour empêcher la croissance de fils dans les emplacements non voulus.

A titre d'exemple, le matériau composant les plots de germination 24 peut être un métal de transition de la colonne IV, V ou VI du tableau périodique des éléments ou un nitrure, un carbure ou un borure d'un métal de transition de la colonne IV, V ou VI du tableau périodique des éléments ou une combinaison de ces composés.

A titre d'exemple, les plots de germination 24 peuvent être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci.

A titre de variante, les plots de germination peuvent être remplacés par une structure de germination comprenant des plots de germination recouverts par une seconde couche de germination ou comprenant une première couche de germination recouverte par la seconde couche de germination. A titre d'exemple, la seconde couche de germination peut être un métal de transition de la colonne IV, V ou VI du tableau périodique des éléments ou un nitrure, un carbure ou un borure d'un métal de transition de la colonne IV, V ou VI du tableau périodique des éléments ou une combinaison de ces composés. La seconde couche de germination peut être réalisée à partir de la première couche de germination. Par exemple, une seconde couche de germination nitrurée peut être réalisée par épitaxie à partir d'une couche en nitrure d'aluminium réalisée par épitaxie. Un procédé de fabrication d'une telle structure de germination est décrit dans la demande de brevet français FR1656008 déposée le 28/06/16.

La couche isolante 32 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (SiOₓN_{y} où x peut être environ égal à 1/2 et y peut être environ égal à 1, par exemple du Si₂ON₂), en oxyde d'aluminium (Al₂O₃), en oxyde d'hafnium (HfO₂) ou en diamant. A titre d'exemple, l'épaisseur de la couche isolante 32 est comprise entre 5 nm et 1 µm, par exemple égale à environ 30 nm.

Les fils 26 sont, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 26 peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 26 peuvent être, au moins en partie, formés à partir de matériaux semiconducteurs comportant majoritairement un composé II-VI. Des exemples d'éléments du groupe TT comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 26 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 26 peut avoir différentes formes, telles que, par exemple, une forme ovale, circulaire ou polygonale, notamment triangulaire, rectangulaire, carrée ou hexagonale. A titre d'exemple, en figure 1A, les fils sont représentés avec une section droite hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 26 peut être compris entre 50 nm et 5 µm. La hauteur de chaque fil 26 peut être comprise entre 250 nm et 50 µm. Chaque fil 26 peut avoir une structure semiconductrice allongée selon un axe sensiblement perpendiculaire à la face 16. Chaque fil 26 peut avoir une forme générale cylindrique. Les axes de deux fils 26 adjacents peuvent être distants de 0,5 µm à 10 µm et de préférence de 1,5 µm à 5 µm. A titre d'exemple, les fils 26 peuvent être régulièrement répartis, notamment selon un réseau hexagonal.

A titre d'exemple, la portion inférieure 28 de chaque fil 26 peut être majoritairement constituée du composé III-N, par exemple du nitrure de gallium, dopé du même type que le substrat 12, par exemple de type N, par exemple au silicium, ou dopé du type opposé par rapport au substrat 12. La portion inférieure 28 s'étend sur une hauteur qui peut être comprise entre 100 nm et 25 µm.

A titre d'exemple, la portion supérieure 30 de chaque fil 26 est au moins partiellement réalisée dans un composé III-N, par exemple du GaN. La portion supérieure 30 peut être dopée de type N, éventuellement moins fortement dopée que la portion inférieure 28 ou ne pas être intentionnellement dopée. La portion supérieure 30 s'étend sur une hauteur qui peut être comprise entre 100 nm et 25 µm.

La coque 34 peut comprendre un empilement de plusieurs couches comprenant notamment :
- une couche active recouvrant la portion supérieure 30 du fil 26 associé ;
- une couche intermédiaire de type de conductivité opposé à la portion inférieure 28 et recouvrant la couche active ; et
- une couche de liaison recouvrant la couche intermédiaire et recouverte par l'électrode 36.

La couche active est la couche depuis laquelle est émise la majorité du rayonnement fourni par la diode électroluminescente élémentaire. Selon un exemple, la couche active peut comporter des moyens de confinement des porteurs de charge électrique, tels que des puits quantiques multiples. Elle est, par exemple, constituée d'une alternance de couches de GaN et de InGaN ayant des épaisseurs respectives de 5 à 20 nm (par exemple 8 nm) et de 1 à 15 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche intermédiaire, par exemple dopée de type P, peut correspondre à une couche semiconductrice ou à un empilement de couches semiconductrices et permet la formation d'une jonction P-N ou P-I-N, la couche active étant comprise entre la couche intermédiaire de type P et la portion supérieure 30 de type N de la jonction P-N ou P-I-N.

La couche de liaison peut correspondre à une couche semiconductrice ou à un empilement de couches semiconductrices et permet la formation d'un contact ohmique entre la couche intermédiaire et l'électrode 36. A titre d'exemple, la couche de liaison peut être dopée très fortement du type opposé à la portion inférieure 28 de chaque fil 26, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer une bonne répartition des porteurs électriques dans la couche active.

L'électrode 36 est adaptée à polariser la couche active de chaque fil 26 et à laisser passer le rayonnement électromagnétique émis par les diodes électroluminescentes. Le matériau formant l'électrode 36 peut être un matériau au moins partiellement transparent dans la gamme de longueur d'onde d'émission des diodes électroluminescentes élémentaires et conducteur électriquement tel que de l'oxyde d'indium-étain (ou ITO, acronyme anglais pour Indium Tin Oxide), de l'oxyde de zinc dopé à l'aluminium, au gallium et/ou à l'indium, ou du graphène. A titre d'exemple, la couche d'électrode 36 a une épaisseur comprise entre 5 nm et 200 nm, de préférence entre 20 nm et 100 nm.

La couche conductrice 38 correspond, de préférence à une couche métallique, par exemple en aluminium, en cuivre, en or, en ruthénium ou en argent, ou à un empilement de couches métalliques, par exemple en titane-aluminium, en silicium-aluminium, en titane-nickel-argent, en cuivre ou en zinc. A titre d'exemple, la couche conductrice 38 a une épaisseur comprise entre 20 nm et 3000 nm, de préférence entre 400 nm et 800 nm. La couche conductrice 38 n'est présente qu'entre les fils et ne recouvre pas la surface émissive de ces derniers. La couche conductrice 38 permet de réduire les pertes résistives lors de la circulation du courant. Elle a également un rôle de réflecteur pour renvoyer vers l'extérieur les rayons émis par les diodes électroluminescentes dans la direction du substrat.

La couche d'encapsulation 40 est réalisée en un matériau isolant au moins partiellement transparent dans la gamme de longueur d'onde d'émission des diodes électroluminescentes élémentaires. L'épaisseur minimale de la couche d'encapsulation 40 est comprise entre 250 nm et 50 µm de sorte que la couche d'encapsulation 40 recouvre de préférence complètement la couche d'électrode 36 au sommet des ensembles D de diodes électroluminescentes. La couche 40 peut remplir complètement l'espace entre les fils. A titre de variante, la couche 40 peut épouser la forme des fils. La couche d'encapsulation 40 peut être réalisée en un matériau inorganique au moins partiellement transparent. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation 40 peut être réalisée en un matériau organique au moins partiellement transparent. A titre d'exemple, la couche d'encapsulation 40 est un polymère silicone, un polymère époxyde, un polymère acrylique ou un polycarbonate.

Les éléments d'isolation électrique 18 peuvent comprendre des tranchées s'étendant sur toute l'épaisseur du substrat 12 et remplies d'un matériau isolant, par exemple un oxyde, notamment de l'oxyde de silicium, ou un polymère isolant. A titre de variante, les parois de chaque tranchée 18 sont recouvertes d'une couche isolante, le reste de la tranchée étant rempli d'un matériau semiconducteur ou conducteur, par exemple du silicium polycristallin. Selon une autre variante, les éléments d'isolation électrique 18 comprennent des régions dopées d'un type de polarité opposé au substrat 12 et s'étendant sur toute la profondeur du substrat 12. A titre d'exemple, chaque tranchée 18 a une largeur supérieure à 1 µm, qui varie notamment de 1 µm à 10 µm, par exemple d'environ 2 µm. Sur les figures 1B et 1C, les éléments d'isolation électrique 18 comprennent, pour chaque portion 20 du substrat 12, une tranchée unique qui délimite la portion 20 du substrat 12. A titre d'exemple, des paires de tranchées adjacentes peuvent être prévues pour isoler électriquement chaque portion 20, la distance entre les deux tranchées 18 d'une paire de tranchées 18 adjacentes étant par exemple supérieure à 5 µm, par exemple d'environ 6 µm.

En général des tranchées si fines ne peuvent être réalisées qu'avec une profondeur limitée, entre une dizaine de micromètres et une centaine de micromètres suivant la technique de gravure et d'isolation choisie. Aussi convient-il d'amincir le substrat 12 jusqu'à l'affleurement des éléments d'isolation électrique 18.

Pour ce faire, une poignée en un matériau rigide peut être fixée temporairement ou définitivement à la couche d'encapsulation 40. Dans le cas où la poignée est fixée définitivement à la couche d'encapsulation 40, la poignée est en un matériau au moins partiellement transparent dans la gamme de longueur d'onde d'émission des diodes électroluminescentes élémentaires. Il peut s'agir de verre, notamment un verre borosilicate, par exemple le verre connu sous l'appellation pyrex, ou de saphir. Après amincissement la face arrière 14 du substrat peut être traitée, puis si le collage est temporaire, la poignée peut être décollée.

Chaque plot conducteur 22 peut correspondre à une couche ou à un empilement de couches recouvrant la face 14. A titre de variante, une couche isolante peut recouvrir partiellement la face 14, chaque plot conducteur 22 étant au contact de la portion semiconductrice 20 associée au travers d'ouvertures gravées dans cette couche isolante.

Comme cela est représenté en figure 1B, chaque mur 42 s'étend depuis la couche conductrice 38 sur toute l'épaisseur H de la couche d'encapsulation 40. A titre de variante, la hauteur de chaque mur 42 peut être inférieure ou supérieure strictement à l'épaisseur H de la couche d'encapsulation 40. Dans le présent mode de réalisation, la hauteur de chaque mur 42 peut être supérieure ou égale à la hauteur des fils 26. De préférence, la largeur de chaque mur 42 est inférieure ou égale au plus petit écart entre deux diodes électroluminescentes élémentaires d'ensembles D adjacents. La largeur L de chaque mur 42 peut être comprise entre 0,5 µm et 12 µm.

La présence des murs 42 permet, de façon avantageuse, d'augmenter le contraste du dispositif optoélectronique 10. En outre, ils permettent d'augmenter la luminance du dispositif optoélectronique 10, notamment selon une direction d'observation perpendiculaire à la face supérieure 16 du substrat 12.

Selon un mode de réalisation, chaque mur 42 est composé d'un bloc d'un matériau solide ou de plusieurs matériaux solides 43.

Selon un mode de réalisation, chaque mur 42 comprend des parois réfléchissantes. Selon un mode de réalisation, les murs 42 sont en un matériau bon conducteur thermique, par exemple en un métal ou un alliage métallique, par exemple en Cu, Ag, CuAg, CuSnAg, CuNi, CuNiAu, Al, ZnAl, ou AlCu. Les murs 42 facilitent alors, en outre, l'évacuation vers le substrat 12 de la chaleur produite lors du fonctionnement des diodes électroluminescentes. A titre de variante, chaque mur 42 peut comprendre un coeur, par exemple un coeur métallique, recouvert d'une couche réfléchissante.

Selon un mode de réalisation, chaque mur 42 comprend des parois opaques. A titre d'exemple, chaque mur 42 peut comprendre un coeur recouvert d'une couche de résine colorée en noir. Cette résine est de préférence adaptée à absorber un rayonnement électromagnétique sur la gamme spectrale incluant le spectre d'émission des diodes électroluminescentes élémentaires et celui des luminophores, lorsqu'ils sont présents. Selon un autre mode de réalisation, chaque mur 42 est réalisé en une résine partiellement transparente à la lumière visible.

Selon un mode de réalisation, les murs 42 ne sont pas réalisés en totalité en résine colorée en noir.

Selon un mode de réalisation, chaque mur 42 comprend une paroi réfléchissante, par exemple du polymère avec des particules de TiO₂.

En figure 1B, on a représenté les murs 42 avec des parois latérales sensiblement parallèles et sensiblement perpendiculaires à la face supérieure 16 du substrat 12. A titre de variante, les parois latérales de chaque mur 42 peuvent être inclinées par rapport à la face supérieure 16 du substrat 12 de façon à se rapprocher l'une de l'autre en s'éloignant du substrat 12. Ceci permet d'accroître la luminance du dispositif optoélectronique 10, notamment selon une direction d'observation perpendiculaire à la face supérieure 16 du substrat 12.

Le dispositif optoélectronique 10 peut, en outre, comprendre des matériaux photoluminescents, également appelés luminophores, dans la couche d'encapsulation 40 ou sur la couche d'encapsulation 40. Les luminophores sont adaptés, lorsqu'ils sont excités par la lumière émise par les diodes électroluminescentes, à émettre de la lumière à une longueur d'onde différente de la longueur d'onde de la lumière émise par les diodes électroluminescentes. Selon un mode de réalisation, des luminophores sont notamment répartis entre les fils 26. De préférence, lorsque les luminophores sont noyés au sein de la couche d'encapsulation 40, le diamètre moyen des luminophores est choisi pour qu'au moins une partie des luminophores se répartisse entre les fils 26. De préférence, le diamètre des luminophores est compris entre 1 nm et 1000 nm.

Le matériau photoluminescent peut être un aluminate, un silicate, un nitrure, un fluorure ou un sulfure, émettant de la lumière à une longueur d'onde dans la gamme allant de 400 à 700 nm sous une excitation lumineuse dont la longueur d'onde est dans la gamme allant de 300 à 500 nm, ou de préférence de 380 à 480 nm.

De préférence, le matériau photoluminescent est un aluminate, notamment un grenat d'aluminium et d'yttrium selon la formule (1) suivante :

(Y₃₋ₓR¹ₓ) (Al_{5-y}R²_{y})O₁₂ (1)

où R¹ et R² sont indépendamment choisis parmi les éléments comprenant les terres rares, les alcalino-terreux et les métaux de transition et x et y varient chacun et indépendamment de 0 à 1,5, de préférence de 0 à 1. De préférence, R¹ et R² sont indépendamment choisis parmi le groupe comprenant le cérium, le samarium, le gadolinium, le silicium, le baryum, le terbium, le strontium, le chrome, le praséodyme et le gallium.

A titre d'exemple de nitrures absorbant et émettant de la lumière dans les gammes de longueur d'onde souhaitées, on peut citer : CaAlSiN₃:Eu, (Ca,Sr)AlSiN3:Eu, Ca₂Si₅Ng:Eu ou (Ca,Sr)Si₅N₈:Eu.

A titre d'exemple de fluorures absorbant et émettant de la lumière dans les gammes de longueur d'onde souhaitées, on peut citer les fluorures de formule K₂MF₆:Mn (où M peut être Si, Ge, Sn ou Ti).

A titre d'exemple de sulfures absorbant et émettant de la lumière dans les gammes de longueur d'onde souhaitées, on peut citer : CaS:Eu, SrCa:Eu, (Sr,Ca)S:Eu et SrGa₂S₄:Eu.

A titre d'exemple d'aluminate absorbant et émettant de la lumière dans les gammes de longueur d'onde souhaitées, on peut citer : Y₃Al₅O₁₂:Ce, (Y,Gd)₃Al₅O₁₂:Ce, Tb₃Al₅O₁₂, (Y,Tb)₃Al₅O₁₂, Lu₃Al₅O₁₂ :Ce et Y₃(Al,Ga)₅O₁₂.

A titre d'exemple de silicates absorbant et émettant de la lumière dans les gammes de longueur d'onde souhaitées, on peut citer : (Sr,Ba)₂SiO₄:Eu, Sr₂SiO₄:Eu, Ba₂SiO₄:Eu, Ca₂SiO₄:Eu, Ca₃SiO₅:Eu et Sr₃SiO₅:Eu.

Selon un mode de réalisation, les luminophores peuvent comprendre des matériaux semiconducteurs adaptés à fournir un confinement quantique dans au moins une direction de l'espace, tels que des boîtes quantiques ou des puits quantiques.

Lorsque la couche d'encapsulation 40 comprend des luminophores, des luminophores différents peuvent être prévus selon les ensembles D de diodes électroluminescentes.

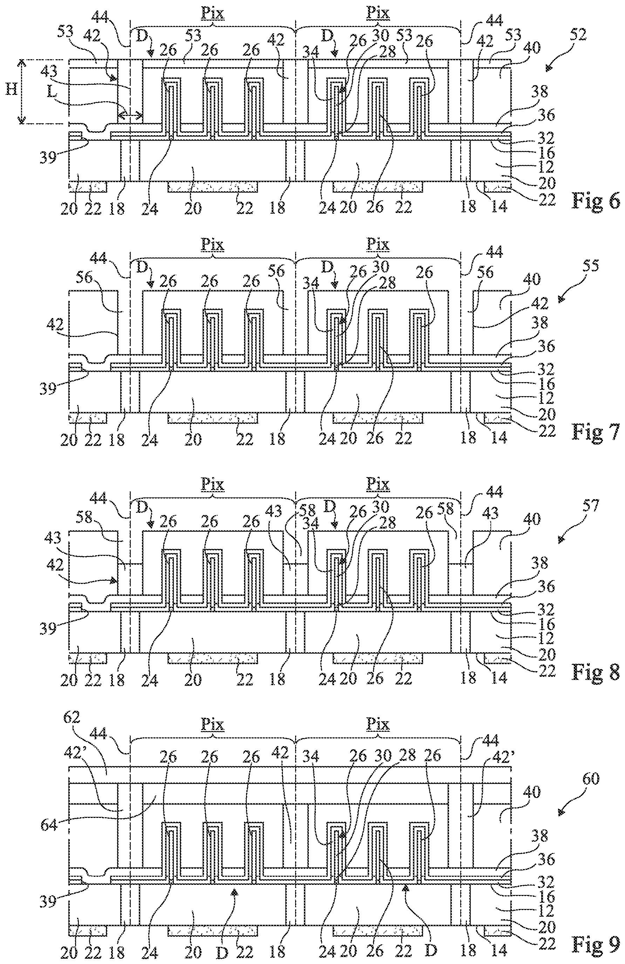

La figure 6 représente un autre mode de réalisation d'un dispositif optoélectronique 52 comprenant l'ensemble des éléments du dispositif optoélectronique 10 et comprenant, en outre, pour chaque sous-pixel d'affichage Pix, un filtre optique 53 sur la couche d'encapsulation 40. De préférence, le filtre 53 n'est seulement pas présent sur les murs 42. Chaque filtre optique 53 peut comprendre une couche, deux couches ou plus de deux couches adaptées à absorber et/ou réfléchir le rayonnement émis par les diodes électroluminescentes élémentaires. Selon un mode de réalisation, les filtres optiques 53 sont transparents dans la gamme spectrale d'émission des luminophores associés au sous-pixel d'affichage lorsqu'ils sont présents. Chaque filtre optique 53 peut comprendre au moins un polymère coloré, photosensible ou non, ou comprendre un empilement de couches diélectriques formant un filtre dichroïque.

Des lentilles peuvent être prévues sur la couche d'encapsulation 40. A titre d'exemple, une lentille peut être prévue pour chaque sous-pixel ou pour des ensembles de sous-pixels.

Selon un mode de réalisation, le dispositif optoélectronique 10 est au moins en partie réalisé selon le procédé décrit dans la demande de brevet FR 3 011 383 A1.

Un mode de réalisation d'un procédé de fabrication du dispositif optoélectronique 10 peut comprendre les étapes suivantes :
(1) Gravure, pour chaque élément d'isolation électrique 18, d'une ouverture dans le substrat 12 du côté de la face avant 16. L'ouverture peut être formée par une gravure de type gravure ionique réactive, par exemple une gravure DRIE. La profondeur de l'ouverture est strictement supérieure à l'épaisseur visée du substrat 12 après une étape d'amincissement décrite par la suite. A titre d'exemple, la profondeur de l'ouverture est comprise entre 10 µm et 200 µm, par exemple environ 35 µm ou 60 µm.
(2) Formation d'une couche isolante, par exemple en oxyde de silicium, sur les parois latérales de l'ouverture, par exemple par un procédé d'oxydation thermique. L'épaisseur de la couche isolante peut être comprise entre 100 nm et 3000 nm, par exemple environ 200 nm.
(3) Remplissage de l'ouverture par un matériau de remplissage, par exemple du silicium polycristallin, du tungstène ou un matériau métallique réfractaire compatible avec les étapes du procédé de fabrication réalisées à températures élevées, déposé par exemple par dépôt chimique en phase vapeur à basse pression (LPCVD, sigle anglais pour Low Pressure Chemical Vapor Déposition). Le silicium polycristallin a, de façon avantageuse, un coefficient de dilatation thermique proche du silicium et permet ainsi de réduire les contraintes mécaniques durant les étapes du procédé de fabrication réalisées à températures élevées.
(4) Polissage mécano-chimique (CMP) pour retrouver la surface du silicium et éliminer tout relief.
(5) Formation des portions de germination 24, des fils 26, de la couche isolante 32 et des coques 34, par croissance par épitaxie, comme cela est décrit dans les demandes de brevet WO 2014/044960 A1 et FR 3 011 383 A1.
(6) Formation de l'électrode 36 sur la totalité de la structure, par exemple par dépôt conforme de type dépôt chimique en phase vapeur (CVD, sigle anglais pour Chemical Vapor Déposition), notamment dépôt de couche atomique (ALD, sigle anglais pour Atomic Layer Déposition), ou dépôt physique en phase vapeur (PVD, sigle anglais pour Physical Vapor Déposition), par pulvérisation cathodique (sputtering en anglais), le dépôt pouvant être suivi d'une étape de recuit de l'électrode.
(7) Formation de l'ouverture 39 au travers de la couche isolante 32 et de la couche d'électrode 36. Lorsque l'ouverture 39 n'est présente qu'au travers de la couche isolante 32, elle est réalisée avant l'étape de formation de l'électrode 36.
(8) Formation de la couche conductrice 38 par exemple par PVD sur l'ensemble de la structure obtenue à l'étape (7) et gravure de cette couche pour exposer la portion de la couche d'électrode 36 recouvrant chaque fil 26.
(9) Traitement thermique de recuit des contacts suivant l'empilement de la couche 38.
(10) Formation des murs 42.
(11) Dépôt de la couche d'encapsulation 40 sur la totalité de la structure obtenue à l'étape (10), par exemple par un procédé de dépôt à la tournette, par un procédé d'impression par jet, par un procédé de sérigraphie ou par un procédé de dépôt de feuille. Lorsque des luminophores différents peuvent être prévus selon les ensembles D de diodes électroluminescentes, une méthode de dépôt sélectif de luminophores consiste à mélanger les grains de luminophore d'une première couleur avec de la résine silicone photosensible, puis après étalement sur l'ensemble du substrat et des diodes électroluminescentes, à fixer des luminophores sur les sous-pixels voulus par photolithographie. On réitère l'opération avec un second luminophore et autant de fois qu'il y a de sous-pixels de couleurs différentes. Une autre méthode est d'utiliser un équipement d'impression de type jet d'encre avec une « encre » composée du mélange silicone-luminophore et d'adjuvants spécifiques. Par impression, à partir d'une cartographie et de l'orientation et d'un référencement des sous-pixels, les luminophores sont déposés aux emplacements requis.
(12) Collage d'une poignée temporaire ou permanente et amincissement du substrat 12 jusqu'à atteindre les éléments 18 d'isolation latérale.
(13) Formation des plots conducteurs 22.

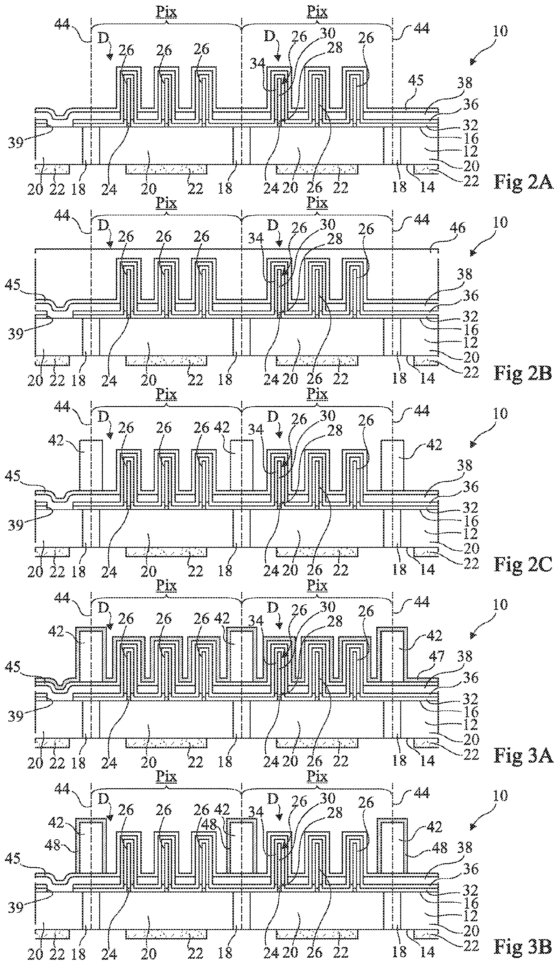

Les figures 2A à 2C illustrent les structures obtenues à des étapes successives d'un mode de réalisation de l'étape (10) du procédé de fabrication décrit précédemment dans le cas où les murs 42 sont en un matériau partiellement transparent dans la gamme spectrale incluant le spectre d'émission des diodes électroluminescentes élémentaires et celui des luminophores, lorsqu'ils sont présents. Le procédé comprend les étapes successives suivantes :
(i) Dépôt conforme sur la structure obtenue après l'étape (9) du procédé de fabrication décrit précédemment d'une couche de passivation 45 isolante électriquement, par exemple une couche de SiON (figure 2A).
(ii) Dépôt d'une couche 46 de résine partiellement transparente dans la gamme spectrale incluant le spectre d'émission des diodes électroluminescentes élémentaires et celui des luminophores, lorsqu'ils sont présents. L'épaisseur minimale de la couche 46 est égale à la hauteur des fils 26 et l'épaisseur maximale de la couche 46 est par exemple d'environ 60 µm.
(iii) Formation, par des étapes de photolithogravure, d'ouvertures dans la couche 46 pour délimiter les murs 42.

Les figures 3A et 3B illustrent les structures obtenues à des étapes successives d'un autre mode de réalisation de l'étape (10) du procédé de fabrication décrit précédemment dans le cas où chaque mur 42 comprend un coeur recouvert d'une coque en un matériau opaque ou réfléchissant dans la gamme spectrale incluant le spectre d'émission des diodes électroluminescentes élémentaires et celui des luminophores, lorsqu'ils sont présents. Le procédé comprend les étapes (i), (ii) et (iii) décrites précédemment pour former le coeur des murs 42 à la différence que le matériau utilisé pour former le coeur peut être quelconque, notamment un matériau métallique ou organique. Le procédé comprend, en outre, les étapes successives suivantes :
(iv) Dépôt conforme, par exemple par revêtement par pulvérisation (en anglais spray coating) d'une couche 47 de résine opaque ou d'une couche réfléchissante sur l'ensemble de la structure obtenue à l'étape (iii). L'épaisseur de la couche 47 peut être comprise entre 0,02 µm et 2 µm, préférentiellement entre 0,05 µm et 0,3 µm (figure 3A).
(v) Retrait, par exemple par des étapes de photolithogravure, des portions de la couche 47 présentes sur les diodes électroluminescentes pour délimiter des portions de résine opaque 48 au niveau des murs 42 (figure 3B).

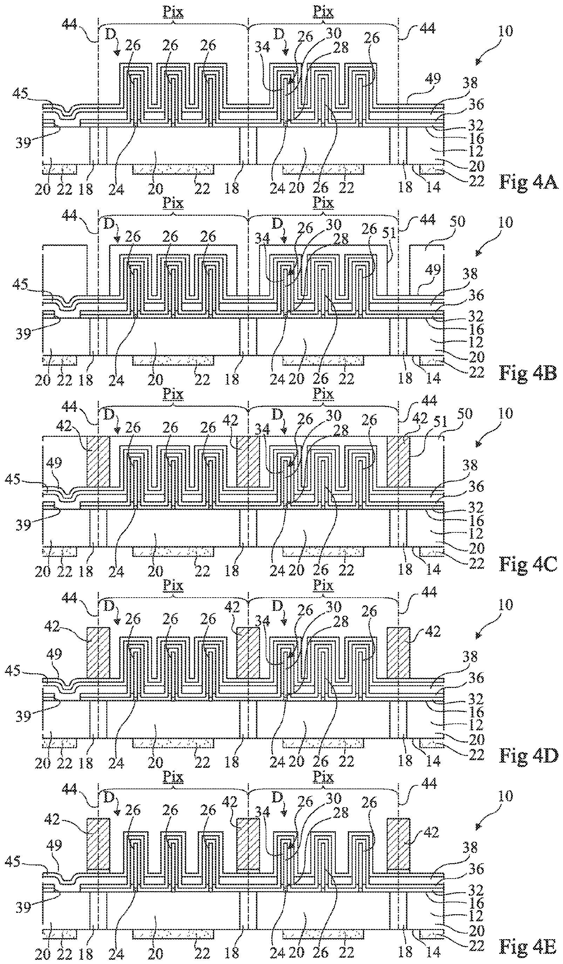

Les figures 4A à 4E illustrent les structures obtenues à des étapes successives d'un autre mode de réalisation de l'étape (10) du procédé de fabrication décrit précédemment dans le cas où chaque mur 42 est métallique. Le procédé comprend l'étape (i) décrite précédemment et comprend, en outre, les étapes successives suivantes :
(a) Dépôt conforme d'une couche 49 favorisant le dépôt d'un matériau métallique. La couche 49 peut comprendre un empilement d'une couche de titane, ayant par exemple une épaisseur comprise entre 20 nm et 400 nm, et d'une couche de cuivre, ayant par exemple une épaisseur comprise entre 100 nm et 2 µm (figure 4A) .
(b) Dépôt d'une couche 50 de résine et formation, par des étapes de photolithogravure, d'ouvertures 51 dans la couche 50 aux emplacements souhaités des murs (figure 4B).
(c) Dépôt, par exemple dépôt électrochimique, d'un matériau métallique dans les ouvertures 51 de la couche 50 de résine pour former les murs 42 (figure 4C), le matériau métallique reposant sur la couche 49.
(d) Retrait de la couche de résine 50 (figure 4D).
(e) Retrait de la couche 49 favorisant le dépôt d'un matériau métallique sur l'ensemble de la structure à l'exception des portions présentes sous les murs 42 (figure 4E).

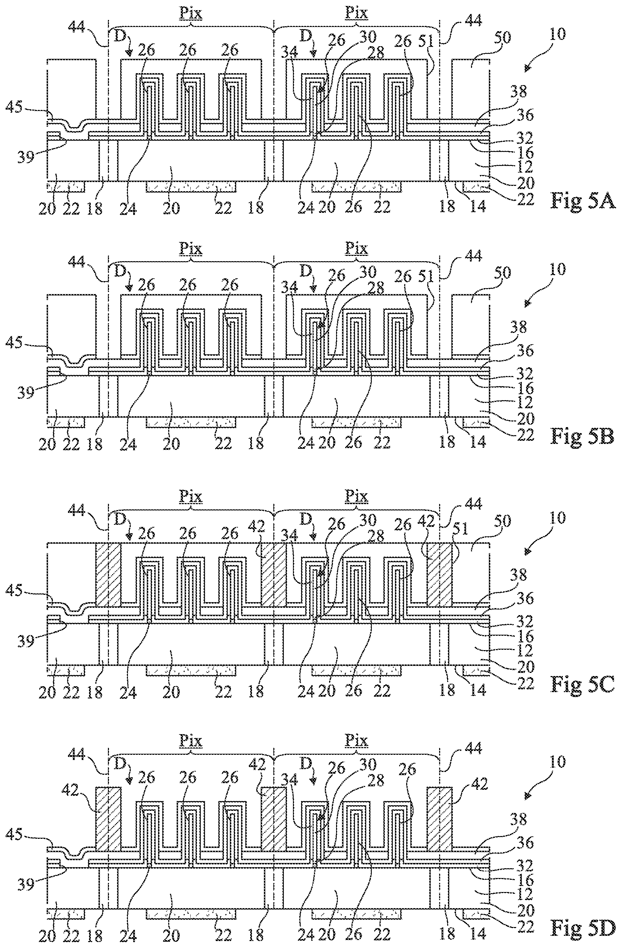

Les figures 5A à 5D illustrent les structures obtenues à des étapes successives d'un autre mode de réalisation de l'étape (10) du procédé de fabrication décrit précédemment dans le cas où chaque mur 42 est métallique. Le procédé comprend l'étape (i) décrite précédemment et comprend, en outre, les étapes successives suivantes :
(a)' Dépôt d'une couche 50 de résine et formation, par des étapes de photolithogravure, d'ouvertures 51 dans la couche 50 aux emplacements souhaités des murs 42 (figure 5A).
(b)' Gravure des portions de la couche isolante 45 au fond des ouvertures 51 (figure 5B).
(c)' Dépôt, par exemple dépôt électrochimique, d'un matériau métallique dans les ouvertures 51 de la couche 50 de résine pour former les murs 42 (figure 5C), le matériau métallique étant au contact de la couche métallique 38.
(d)' Retrait de la couche de résine 50 (figure 5D).

La figure 7 représente un autre mode de réalisation d'un dispositif optoélectronique 55 comprenant l'ensemble des éléments du dispositif optoélectronique 10 à la différence que les murs 42 correspondent à des ouvertures 56 remplies d'air prévues dans la couche d'encapsulation 40. Les ouvertures 56 peuvent avoir les mêmes dimensions que celles décrites précédemment pour les murs 42. La luminance du dispositif optoélectronique 55, notamment selon une direction d'observation perpendiculaire à la face supérieure 16 du substrat 12, peut être supérieure à celle du dispositif optoélectronique 10.

La figure 8 représente un autre mode de réalisation d'un dispositif optoélectronique 57 comprenant l'ensemble des éléments du dispositif optoélectronique 10 à la différence que, pour au moins certains des murs 42, et de préférence de chaque mur 42, le bloc solide 43 a une hauteur strictement inférieure à l'épaisseur de la couche d'encapsulation 40 et se prolonge par une ouverture 58 remplie d'air sur le reste de l'épaisseur de la couche d'encapsulation 40.

Selon un mode de réalisation, les murs 42 ont des hauteurs différentes. Selon un mode de réalisation, la hauteur des murs situés entre deux sous-pixels d'affichage Pix associés à un même pixel d'affichage peut être inférieure à la hauteur des murs séparant deux sous-pixels d'affichage Pix associés à deux pixels d'affichage différents. Selon un mode de réalisation, les sous-pixels d'affichage correspondant à une même couleur peuvent être disposés en bandes et la hauteur des murs situés entre deux sous-pixels d'affichage Pix associés à une même bande peut être inférieure à la hauteur des murs séparant deux sous-pixels d'affichage Pix associés à deux bandes différentes.

La figure 9 représente un autre mode de réalisation d'un dispositif optoélectronique 60 comprenant l'ensemble des éléments du dispositif optoélectronique 10 à la différence que certains murs désignés par la référence 42', par exemple les murs à la périphérie du dispositif optoélectronique 60 ont une hauteur supérieure à l'épaisseur de la couche d'encapsulation 40. Le dispositif optoélectronique 60 comprend, en outre, une plaque 62 d'un matériau sensiblement transparent, par exemple une plaque de verre, reposant sur les extrémités des murs 42'. Un film 64 d'air ou de vide partiel, par exemple à une pression inférieure à 100 mbar (10000 Pa), est présent entre la plaque transparente 62 et la couche d'encapsulation 40. La hauteur des murs 42' peut être comprise entre 10 µm et 100 µm. La largeur des murs 42' peut être comprise entre 0,5 µm et 200 µm.

Un avantage du dispositif optoélectronique 60 est que la plaque 62 sert de capot de protection pour la couche d'encapsulation 40. En particulier, dans le cas où la couche d'encapsulation 40 contient des luminophores, la plaque 62 permet de protéger les luminophores. En outre, le film d'air ou de vide 64 peut correspondre à un volume sensiblement étanche, de sorte que les risques d'oxydation des murs 42 qui ne sont pas à la périphérie du dispositif optoélectronique sont réduits. La présence du film d'air ou de vide 64 permet d'augmenter l'extraction de la lumière hors du dispositif optoélectronique 60 par rapport au cas où la plaque transparente 62 reposerait directement au contact de la couche d'encapsulation 40. A titre de variante, la hauteur des murs 42 peut être supérieure à l'épaisseur de la couche d'encapsulation 40 et les murs 42 peuvent également être au contact de la plaque 62.

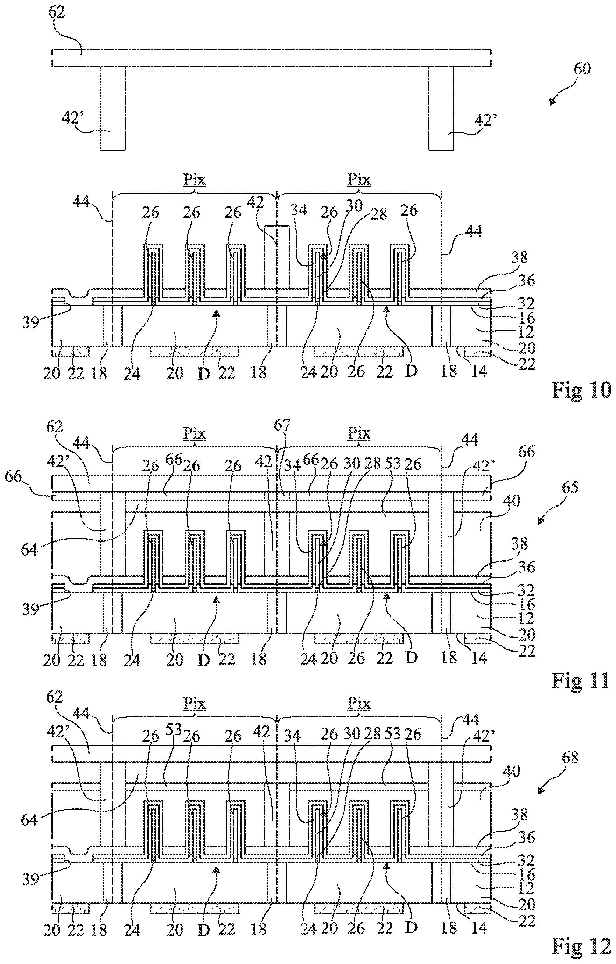

La figure 10 illustre une étape d'un mode de réalisation d'un procédé de fabrication du dispositif optoélectronique 60. Dans ce mode de réalisation, les étapes (1) à (10) décrites précédemment peuvent être mises en oeuvre. Le procédé comprend, indépendamment de ces étapes, la formation des murs 42' sur la plaque 62, par exemple de façon analogue à la formation des murs 42. A titre de variante, les murs 42' peuvent être formés par gravure d'une couche de silicium d'un substrat de type SOI (sigle anglais pour Silicon On Insulator), la plaque 62 pouvant alors correspondre à la couche isolante du substrat SOI.

La couche d'encapsulation 40 peut être déposée sur les fils 26 et réticulée et des ouvertures sont formées dans la couche d'encapsulation 40 pour permettre le passage des murs 42'. Les murs 42' sont alors introduits dans les ouvertures prévues dans la couche d'encapsulation 40 et fixés à la couche métallique 38, par exemple par collage anodique. A titre de variante, la couche d'encapsulation 40 peut être déposée sur les fils 26 et, avant la réticulation de la couche d'encapsulation 40, les murs 42' sont rapprochés de la couche métallique 38 au travers de la couche d'encapsulation 40. La couche d'encapsulation 40 est alors réticulée. Selon cette variante, la couche d'encapsulation 40 peut être présente entre chaque mur 42' et la couche métallique 38.

Un autre mode de réalisation du dispositif optoélectronique 60 est de fabriquer les murs 42' en même temps que les murs 42, notamment comme cela a été décrit précédemment en relation avec les figures 4A à 4E et 5A à 5D puis de coller la plaque 62 aux murs 42'.

La figure 11 représente un autre mode de réalisation d'un dispositif optoélectronique 65 comprenant l'ensemble des éléments du dispositif optoélectronique 60 représenté en figure 9 et comprenant, en outre, des filtres optiques 66 prévue sur la plaque 62. Les filtres optiques 66 peuvent avoir la même structure que les filtres optiques 53 décrits précédemment. Des éléments 67 opaques dans la gamme spectrale incluant le spectre d'émission des diodes électroluminescentes élémentaires et celui des luminophores, lorsqu'ils sont présents, peuvent être prévus entre certains des filtres 66.

La figure 12 représente un autre mode de réalisation d'un dispositif optoélectronique 68 comprenant l'ensemble des éléments du dispositif optoélectronique 60 représenté en figure 9 et comprenant, en outre, sur la couche d'encapsulation 40 les filtres optiques 53 décrits précédemment en relation avec la figure 6.

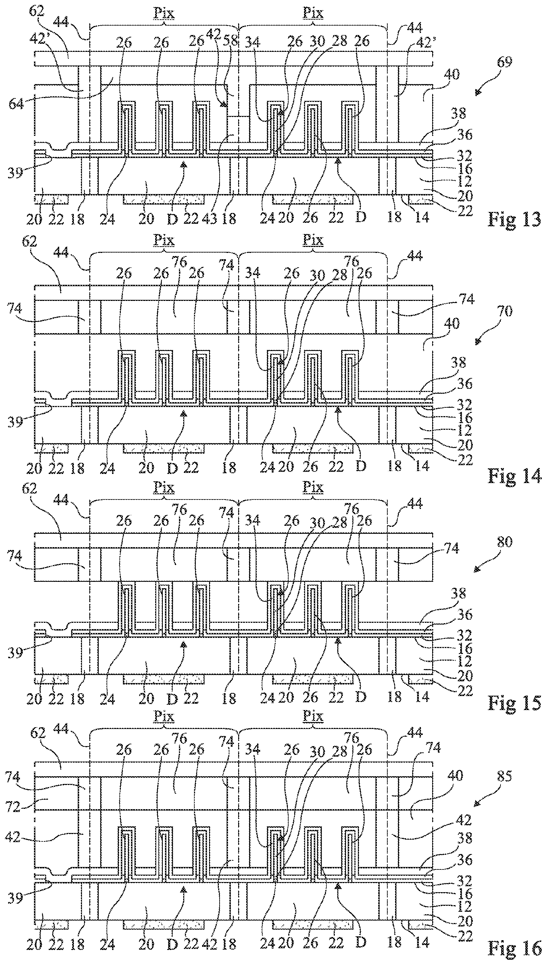

La figure 13 représente un autre mode de réalisation d'un dispositif optoélectronique 69 comprenant l'ensemble des éléments du dispositif optoélectronique 60 représenté en figure 9 à la différence qu'au moins certains des murs 42 ont la structure du dispositif optoélectronique 55, c'est-à-dire comprenant chacun le bloc 43 ayant une hauteur inférieure à l'épaisseur de la couche d'encapsulation 40 et se prolongeant par l'ouverture 58 remplie d'air ou de vide. A titre de variante, les murs 42 peuvent correspondre à des ouvertures remplies d'air ou de vide comme pour le dispositif optoélectronique 55 représenté en figure 7.

La figure 14 représente un autre mode de réalisation d'un dispositif optoélectronique 70 comprenant l'ensemble des éléments du dispositif optoélectronique 60 représenté en figure 9 à la différence que les murs 42 et 42' ne sont pas présents et que le film d'air ou de vide 64 est remplacé par une couche 72 contenant des luminophores interposée entre la plaque 62 sensiblement transparente et la couche d'encapsulation 40, la couche de luminophores 72 étant au contact de la plaque 62 et de la couche d'encapsulation 40. L'épaisseur de la couche de luminophores 72 peut être comprise entre 0,2 µm et 50 µm et préférentiellement entre 1 µm et 30 µm. Des murs 74 s'étendent dans la couche de luminophores 72 et divisent la couche 72 en portions 76 contenant des luminophores. Les murs 74 peuvent avoir la même structure et la même composition que celles décrites précédemment pour les murs 42. Selon un mode de réalisation, les murs 74 ou les parois des murs sont opaques dans la gamme spectrale incluant le spectre d'émission des diodes électroluminescentes élémentaires et celui des luminophores, lorsqu'ils sont présents. Selon un mode de réalisation, chaque mur 74 comprend des parois réfléchissantes. Des luminophores différents peuvent être prévus dans différentes portions 76.

Dans le présent mode de réalisation, les luminophores sont prévus au niveau des portions 76 et ne sont pas présents dans la couche d'encapsulation 40. Ceci permet, de façon avantageuse, l'utilisation de luminophores qui seraient trop gros pour s'insérer entre les fils 26. Dans le présent mode de réalisation, la fonction d'amélioration du contraste et de la luminance est remplie par les murs 74 prévus dans la couche de luminophores 72. Toutefois, les modes de réalisation décrits dans la présente description dans lesquels des murs sont présents entre les ensembles de diodes électroluminescentes peuvent être plus favorables pour l'amélioration du contraste. La figure 15 représente un autre mode de réalisation d'un dispositif optoélectronique 80 comprenant l'ensemble des éléments du dispositif optoélectronique 70 représenté en figure 14 à la différence que la couche d'encapsulation 40 n'est pas présente et que la couche 72 de luminophores repose directement sur les sommets des fils 26.

La figure 16 représente un autre mode de réalisation d'un dispositif optoélectronique 85 comprenant l'ensemble des éléments du dispositif optoélectronique 70 représenté en figure 14 et comprend en outre les murs 42 dans la couche d'encapsulation 40 comme pour le dispositif optoélectronique 10. Dans le présent mode de réalisation, la hauteur des murs 42 est sensiblement égale à l'épaisseur de la couche d'encapsulation 40. De préférence, les murs 42 sont dans le prolongement des murs 74. La présence des murs 42 et 74 permet d'obtenir une augmentation du contraste et de la luminance par rapport aux dispositifs optoélectroniques 70 et 80. A titre de variante, les murs 42 peuvent être remplacés par des ouvertures remplies d'air ou de vide comme pour le dispositif optoélectronique 55 décrit précédemment en relation avec la figure 7. A titre de variante, la hauteur des murs 42 peut être inférieure à l'épaisseur de la couche d'encapsulation 40 et des ouvertures remplies d'air peuvent être prévues dans le prolongement des murs comme pour le dispositif optoélectronique 57 décrit précédemment en relation avec la figure 8.

Selon un autre mode de réalisation, les murs 42 et 74 du dispositif optoélectronique 85 sont monoblocs et sont formés comme cela a été décrit précédemment pour les murs 42' en relation avec la figure 10.

A titre de variante, le dispositif optoélectronique 70, 80 ou 85 peut en outre comprendre des filtres optiques. Chaque filtre optique est interposé entre la plaque 62 et l'une des portions 76 contenant des luminophores. Les filtres optiques peuvent être fabriqués avant la formation des murs 74 et des portions 76 contenant des luminophores.

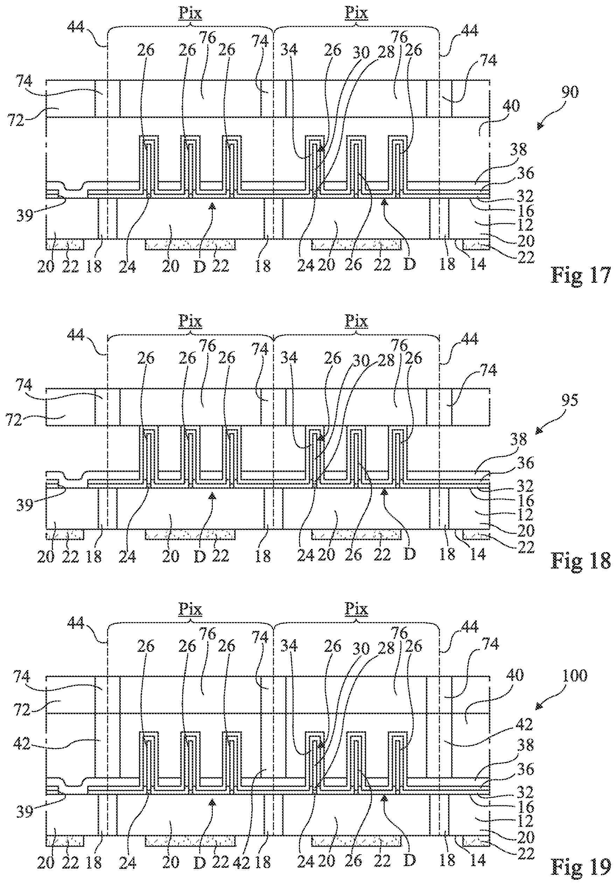

La figure 17 représente un autre mode de réalisation d'un dispositif optoélectronique 90 comprenant l'ensemble des éléments du dispositif optoélectronique 70 représenté en figure 14 à la différence que la plaque 62 sensiblement transparente n'est pas présente. A titre d'exemple, les murs 74 font partie d'une grille métallique délimitant des cases dans lesquelles sont logées les portions 76 contenant les luminophores.

La figure 18 représente un autre mode de réalisation d'un dispositif optoélectronique 95 comprenant l'ensemble des éléments du dispositif optoélectronique 90 représenté en figure 17 à la différence que la couche d'encapsulation 40 n'est pas présente comme pour le dispositif optoélectronique 80 et que la couche 72 de luminophores repose directement sur les sommets des fils 26.

La figure 19 représente un autre mode de réalisation d'un dispositif optoélectronique 100 comprenant l'ensemble des éléments du dispositif optoélectronique 90 représenté en figure 17 et comprenant en outre les murs 42 dans la couche d'encapsulation 40 comme pour le dispositif optoélectronique 85.

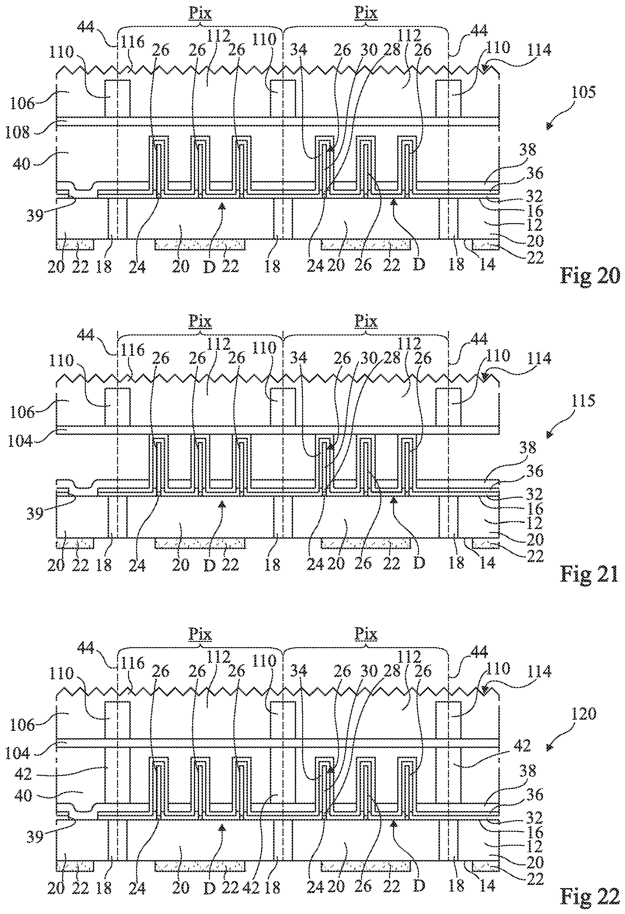

La figure 20 représente un autre mode de réalisation d'un dispositif optoélectronique 105 comprenant l'ensemble des éléments du dispositif optoélectronique 70 représenté en figure 14 à la différence que la plaque 62 et la couche de luminophores 72 sont remplacées par une couche 106 monocristalline d'un matériau photoluminescent fixée à la couche d'encapsulation 40 par l'intermédiaire d'une couche 108 d'un matériau de collage, par exemple une couche de silicone. Le matériau photoluminescent peut correspondre à l'un des matériaux photoluminescents décrits précédemment pour le dispositif optoélectronique 10. La couche photoluminescente 106 comprend des ouvertures 110 qui s'étendent sur une partie de l'épaisseur de la couche 106 mais ne traversent pas la totalité de la couche 106. Les ouvertures 110 débouchent du côté de la couche d'encapsulation 40. Les ouvertures 110 sont, de préférence situées dans le prolongement des murs 42 et délimitent des portions photoluminescentes 112 dans la couche 106, chaque portion photoluminescente 112 étant située en vis-à-vis de l'un des ensembles D de diodes électroluminescentes. Les ouvertures 110 peuvent être remplies partiellement ou en totalité d'air ou de vide ou être remplies partiellement ou en totalité d'un matériau bon conducteur thermique, par exemple du métal ou un alliage métallique. La couche photoluminescente 112 peut comprendre une texturation sur sa face 114 visible par un observateur, c'est-à-dire des reliefs 116 qui augmentent l'extraction de la lumière par la face 114. Les ouvertures 110 peuvent être réalisées par sciage.

La figure 21 représente un autre mode de réalisation d'un dispositif optoélectronique 115 comprenant l'ensemble des éléments du dispositif optoélectronique 105 représenté en figure 20 à la différence que la couche d'encapsulation 40 n'est pas présente comme pour le dispositif optoélectronique 80 et que la couche photoluminescente 112 repose directement sur les sommets des fils 26 par l'intermédiaire de la couche de colle 108.

La figure 22 représente un autre mode de réalisation d'un dispositif optoélectronique 120 comprenant l'ensemble des éléments du dispositif optoélectronique 105 représenté en figure 20 et comprend en outre les murs 42 dans la couche d'encapsulation 40 comme pour le dispositif optoélectronique 85.

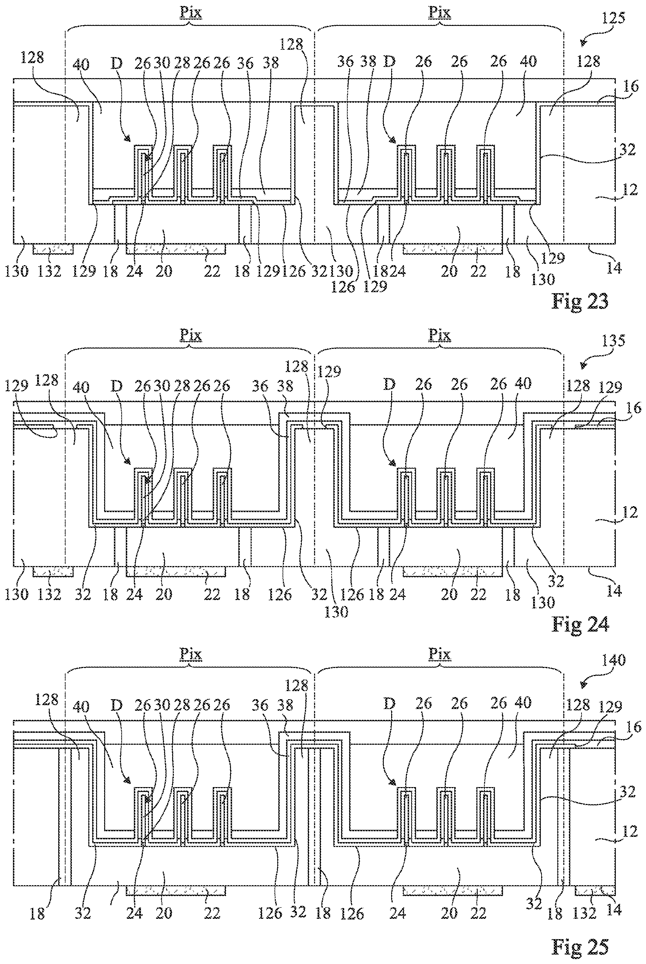

La figure 23 représente un autre mode de réalisation d'un dispositif optoélectronique 125 comprenant l'ensemble des éléments du dispositif optoélectronique 10 représenté en figure 1B à la différence que chaque ensemble D de diodes électroluminescents est formé dans le fond d'une cuvette 126 qui s'étend dans le substrat 12 depuis la face 16 et que les murs 42 correspondent à des portions 128 du substrat 12 qui délimitent la cuvette 126. Les murs 128 s'étendent notamment entre les ensembles D de diodes électroluminescentes de chaque paire d'ensembles D adjacentes. Les portions 128 du substrat 12 formant les murs sont isolés électriquement des portions 20 du substrat 12 adjacents par les tranchées d'isolation électrique 18. La profondeur de chaque cuvette 126 est comprise entre 2 µm et 100 µm, par exemple environ 25 µm.

La couche isolante 32 recouvre les parois de chaque cuvette 126 et la totalité des murs 128. Pour chaque ensemble de diodes électroluminescentes D, la couche d'électrode 36 s'étend sur les fils 26 et sur le fond de la cuvette 126 dans laquelle est formé l'ensemble D de diodes électroluminescentes et la couche conductrice 38 s'étend sur la couche d'électrode 36 entre les fils 26. Dans le présent mode de réalisation, la couche d'électrode 36 et la couche conductrice 38 ne s'étendent pas sur les murs 128. La liaison électrique entre les couches d'électrode 36 et/ou 38 de deux ensembles D de diodes électroluminescentes adjacentes est réalisée par l'intermédiaire du mur 128 séparant les deux ensembles D. Dans ce but, pour chaque sous-pixel d'affichage Pix, la couche d'électrode 36 et/ou 38 est au contact de la portion de substrat 128 par l'intermédiaire d'une ouverture 129 prévue dans la couche isolante 32. Les couches d'électrode 36 et/ou 38 de tous les ensembles D de diodes électroluminescentes sont donc reliées électriquement. Dans le présent mode de réalisation, les tranchées 18 sont situées dans le substrat 14 au niveau de chaque cuvette 126 et séparent les portions 20 du substrat 14 des portions 130 du substrat 14 contenant les murs 128. Les couches d'électrode 36 et/ou 38 sont connectées électriquement aux portions 130. En outre, il peut être prévu une portion conductrice 132 sur la face 14 au contact de l'une des portions 130 de substrat formant un mur relié électriquement aux couches d'électrode 36 afin de permettre la polarisation des couches d'électrode 36. La figure 24 représente un autre mode de réalisation d'un dispositif optoélectronique 135 comprenant l'ensemble des éléments du dispositif optoélectronique 120 représenté en figure 23 à la différence que la couche d'électrode 36 et/ou 38 s'étend sur tous les fils 26 et sur les murs 128 et est commune à tous les ensembles D de diodes électroluminescentes. Dans ce cas, la couche 32 n'est pas ouverte en bas de cuvette 126 mais être ouverte au sommet d'au moins certains des murs 128 délimitant les cuvettes 126. Dans ce but, la couche d'électrode 36 et/ou 38 est au contact au sommet d'au moins certains des murs 128 par l'intermédiaire d'ouvertures 129 prévues dans la couche isolante 32.

La figure 25 représente un autre mode de réalisation d'un dispositif optoélectronique 140 comprenant l'ensemble des éléments du dispositif optoélectronique 135 représenté en figure 24 à la différence que les tranchées 18 sont présentes dans le substrat 14 au niveau des murs 128.

Dans le mode de réalisation représenté sur les figures 23, 24 et 25, les flancs latéraux des murs 128 sont sensiblement perpendiculaires aux faces 14 et 16 du substrat 12. A titre de variante, les flancs latéraux des murs 128 peuvent être inclinés par rapport aux faces 14 et 16 d'un angle différent de 90° et orientés de façon à réfléchir les rayons lumineux émis par les diodes électroluminescentes élémentaires, et les luminophores lorsqu'ils sont présents, vers l'extérieur du dispositif optoélectronique 125.

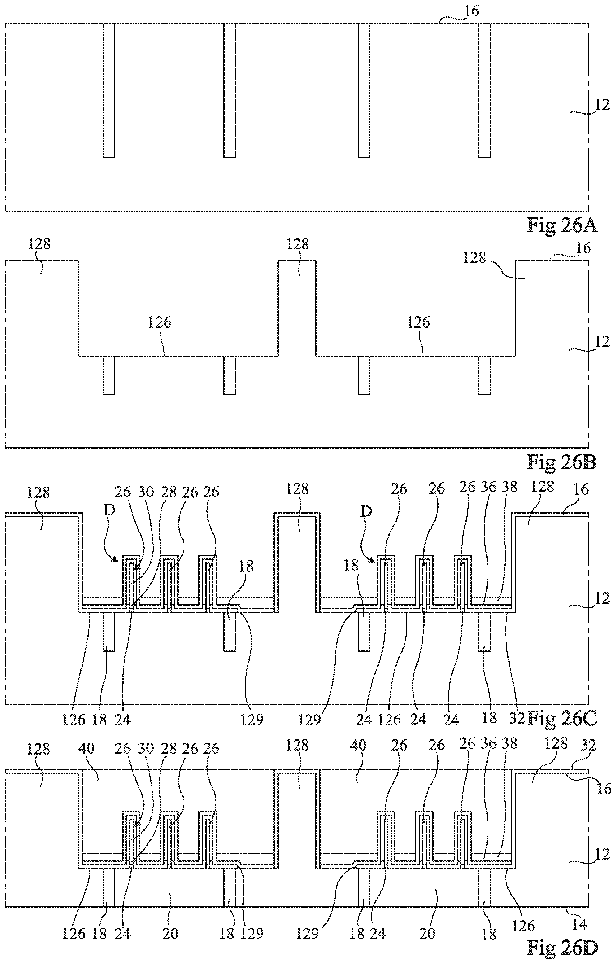

Les figures 26A à 26D illustrent les structures obtenues à des étapes successives d'un mode de réalisation du dispositif optoélectronique 125.

La figure 26A représente la structure obtenue après la mise en oeuvre des étapes (1), (2), (3) et (4) décrites précédemment qui conduisent à la formation, dans le substrat 12 non encore aminci, des tranchées d'isolation électrique 18.

La figure 26B représente la structure obtenue après la formation des cuvettes 126 dans la face 16 du substrat 12.

La figure 26C représente la structure obtenue après la mise en oeuvre de l'étape (5) décrite précédemment qui conduit à la formation, dans chaque cuvette 126, d'un ensemble D de diodes électroluminescentes et à la formation de la couche isolante 32 dans les cuvettes 126 et sur les murs 128. Les ouvertures 129 ont ensuite été formées dans la couche isolante 32 et l'étape (6) décrite précédemment a été mise en oeuvre pour former la couche d'électrode 36. Selon le procédé mis en oeuvre, la couche d'électrode 36 peut être déposée également sur les murs 128. Une étape de retrait des portions de la couche d'électrode présente sur les murs 128 peut alors être prévue. L'étape (8) décrite précédemment a ensuite été mise en oeuvre pour former la couche conductrice 38 dans chaque cuvette 126 entre les fils 26.

La figure 26D représente la structure obtenue après la mise en oeuvre de l'étape (9) décrite précédemment de recuit thermique, de l'étape (11) décrite précédemment de dépôt d'une couche d'encapsulation dans les cuvettes 126 et sur les murs 128 suivie d'une étape de gravure ou de planarisation pour obtenir des couches d'encapsulation 40 seulement dans les cuvettes 126 et de l'étape (12) décrite précédemment d'amincissement du substrat 12 jusqu'à atteindre les éléments 18 d'isolation latérale.

Le procédé comprend en outre l'étape (13) décrite précédemment de formation des plots conducteurs 22.

Dans les modes de réalisation décrits précédemment, le dispositif optoélectronique 10 est fixé à un autre circuit par des éléments conducteurs fusibles, non représentés, par exemple des billes de soudure ou des billes d'indium fixées aux plots conducteurs 22. L'assemblage du dispositif optoélectronique 10 sur un autre circuit, notamment sur un circuit de commande, se fait au moyen de techniques conventionnelles d'hybridation matricielle, au moyen de billes fusibles ou par mise en regard de matériaux fusibles, par exemple en indium, ou en SnAg, ou de colonnes de cuivre ou de plots d'or (technologie Stud Bump) ou par collage moléculaire conducteur (cuivre sur cuivre). L'empilement métallique formant les plots conducteurs 22 est choisi de manière à être compatible avec la technologie d'assemblage choisie. A titre d'exemple, les plots conducteurs 22 peuvent être en Cu ou Ti-Ni-Au, Sn-Ag ou Ni-Pd-Au.

La couche active de la coque 34 des diodes électroluminescentes élémentaires d'au moins l'un des ensembles de diodes électroluminescentes D peut être fabriquée de manière différente de la couche active de la coque des diodes électroluminescentes élémentaires d'au moins un autre ensemble de diodes électroluminescentes. Par exemple, la couche active de la coque 34 d'un premier ensemble peut être adaptée pour émettre une lumière à une première longueur d'onde, par exemple une lumière bleue et la couche active de la coque 34 d'un deuxième ensemble peut être adaptée pour émettre une lumière à une deuxième longueur d'onde différente de la première longueur d'onde, par exemple une lumière verte. Ceci peut être obtenu, par exemple, en adaptant dans chaque ensemble le pas et la taille des fils, ce qui a pour conséquence de modifier l'épaisseur et la composition des puits quantiques composant ces couches actives.

De plus, un troisième ensemble peut être adapté pour émettre une lumière à une troisième longueur d'onde différente des première et deuxième longueurs d'onde, par exemple une lumière rouge. Ainsi la composition des lumières bleue, verte, et rouge peut être choisie pour qu'un observateur perçoive une lumière blanche par composition des couleurs, chaque diode, ou ensemble de diodes, émettant à une première, deuxième et troisième longueur d'onde pouvant être adressée indépendamment des autres afin d'ajuster la couleur.

Dans le mode de réalisation décrit précédemment, la couche isolante 32 recouvre la totalité du pourtour de la portion inférieure 28 de chaque fil 26. A titre de variante, une partie de la portion inférieure 28, voire la totalité de la portion inférieure 28, peut ne pas être recouverte par la couche isolante 32. Dans ce cas, la coque 34 peut recouvrir chaque fil 26 sur une hauteur supérieure à la hauteur de la portion supérieure 30, voire sur la totalité de la hauteur du fil 26. En outre, dans le mode de réalisation décrit précédemment, la couche isolante 32 ne recouvre pas le pourtour de la portion supérieure 30 de chaque fil 26. A titre de variante, la couche isolante 32 peut recouvrir une partie de la portion supérieure 30 de chaque fil 26. De plus, selon une autre variante, la couche isolante 32 peut, pour chaque fil 26, recouvrir partiellement la portion inférieure de la coque 34. Selon un autre mode de réalisation, la couche 32 peut ne pas être présente, notamment dans le cas où les plots de germination 24 sont remplacés par une couche de germination recouverte d'une couche diélectrique et que les fils sont formés sur la couche de germination dans des ouvertures prévues dans la couche diélectrique.

Le dispositif optoélectronique 10 peut être rapporté sur un autre circuit intégré, notamment un circuit de commande, comprenant des composants électroniques, notamment des transistors, utilisés pour la commande des ensembles de diodes électroluminescentes du dispositif optoélectronique 10.

En fonctionnement, les plots conducteurs 22 reliés électriquement à la couche conductrice 38 peuvent être reliés à une source d'un premier potentiel de référence. Le plot conducteur 22 au contact de la portion 20 du substrat 12 sur laquelle reposent les diodes électroluminescentes élémentaires d'un ensemble D de diodes électroluminescentes à activer peut être relié à une source d'un deuxième potentiel de référence de façon à faire circuler un courant au travers des diodes électroluminescentes élémentaires de l'ensemble D considéré. Chaque plot conducteur 22 pouvant s'étendre sur une partie importante de la portion 20 associée, une répartition homogène du courant peut être obtenue.

Sur les figures 1A à 1C, la couche conductrice 38 est représentée au contact avec des portions 20 le long d'un côté du dispositif optoélectronique 10. A titre de variante, la couche conductrice 38 peut être au contact avec des portions 20 sur tout le pourtour du dispositif optoélectronique 10.

Dans les modes de réalisation représentés sur les figures 1A à 1C, le dispositif optoélectronique 10 est relié électriquement à un circuit externe par l'intermédiaire de matériaux fusibles prévus du côté de la face inférieure 14 du substrat 12. Toutefois, d'autres modes de connexion électrique peuvent être envisagés.

Dans les modes de réalisation décrits précédemment, le substrat 12 est un substrat en un matériau semiconducteur ou conducteur. Selon un autre mode de réalisation, le substrat 12 est en totalité ou en partie en un matériau isolant, par exemple en dioxyde de silicium (SiO₂) ou en saphir. La connexion électrique entre les plots conducteurs 22 et la couche conductrice 38 ou les plots de germination 24 peut être réalisée en utilisant des éléments conducteurs traversant le substrat 12 sur la totalité de son épaisseur, par exemple des vias traversant ou TSV (acronyme anglais pour Through Silicon Via).

Selon un autre mode de réalisation, au moins un plot conducteur est prévu au contact de la couche conductrice 38 du côté de la face avant 16. La couche d'encapsulation 40 comprend alors une ouverture qui expose le plot conducteur. Ni la couche conductrice 38 ni la couche d'électrode 36 ne sont en contact électrique avec le substrat semiconducteur 12. Le plot conducteur est relié électriquement à un circuit externe, non représenté, par un fil non représenté. Plusieurs plots conducteurs peuvent être répartis sur la couche conductrice 38, par exemple à la périphérie du dispositif optoélectronique.

Divers modes de réalisation avec diverses variantes ont été décrits ci-dessus. On note que l'homme de l'art peut combiner divers éléments de ces divers modes de réalisation et variantes sans faire preuve d'activité inventive. A titre d'exemple, la structure du dispositif optoélectronique 120 représenté sur la figure 22 peut être mise en oeuvre avec la structure du dispositif optoélectronique 55 représenté sur la figure 7 ou la structure du dispositif optoélectronique 57 représenté sur la figure 8.

Les revendications qui suivent définissent l'objet de la protection conférée par la présente invention.

## Revendications

1. Dispositif optoélectronique (10) comprenant :
un substrat (12) comprenant des première et deuxième faces opposées (14, 16), des éléments (18) d'isolation électrique latérale s'étendant de la première face (16) à la deuxième face (14) et délimitant dans le substrat des premières portions semiconductrices ou conductrices (20) isolées électriquement les unes des autres,
le dispositif optoélectronique comprenant, en outre, pour chaque première portion, un ensemble (D) de diodes électroluminescentes reposant sur la première face et reliées électriquement à la première portion, chaque diode électroluminescente comprenant au moins un élément semiconducteur (26) filaire, conique ou tronconique, intégrant ou recouvert au sommet et/ou au moins sur une partie de ses faces latérales par une coque (34) comprenant au moins une couche active adaptée à fournir la majorité du rayonnement de la diode électroluminescente,
le dispositif optoélectronique comprenant, en outre, une couche d'électrode (36) conductrice et au moins partiellement transparente au moins dans la gamme de longueur d'onde d'émission des diodes électroluminescentes recouvrant toutes les diodes électroluminescentes, une couche de protection (40 ; 72 ; 106) contenant un premier matériau diélectrique et au moins partiellement transparent au moins dans la gamme de longueur d'onde d'émission des diodes électroluminescentes et d'éventuels luminophores présents dans la couche de protection, et des murs (42 ; 74 ; 110 ; 128) s'étendant au moins en partie dans la couche de protection et délimitant dans la couche de protection des deuxièmes portions entourant ou en vis-à-vis des ensembles (D) de diodes électroluminescentes, les murs contenant au moins un deuxième matériau différent du premier matériau et compris dans le groupe comprenant l'air, un métal, un matériau semiconducteur, un alliage métallique, un matériau partiellement transparent au moins dans la gamme de longueur d'onde d'émission des diodes électroluminescentes et des éventuels luminophores, et un coeur en un matériau au moins partiellement transparent au moins dans la gamme de longueur d'onde d'émission des diodes électroluminescentes et des éventuels luminophores recouvert d'une couche opaque ou réfléchissante au moins dans la gamme de longueur d'onde d'émission des diodes électroluminescentes et des éventuels luminophores.

2. Dispositif optoélectronique selon la revendication 1, dans lequel la couche de protection (40) entoure chaque diode électroluminescente.

3. Dispositif optoélectronique selon la revendication 1 ou 2, dans lequel la couche de protection (72 ; 106) n'entoure pas les diodes électroluminescentes.

4. Dispositif optoélectronique selon l'une quelconque des revendications 1 à 3, dans lequel les murs (42 ; 74) s'étendent au moins sur la totalité de l'épaisseur de la couche de protection (40 ; 72).

5. Dispositif optoélectronique selon l'une quelconque des revendications 1 à 4, dans lequel au moins l'un des murs (42) comprend un bloc (43) solide se prolongeant par une ouverture (58) remplie d'air.

6. Dispositif optoélectronique selon l'une quelconque des revendications 1 à 5, dans lequel la couche de protection (40) comprend des luminophores.

7. Dispositif optoélectronique selon la revendication 6, dans lequel les luminophores comprennent des matériaux semiconducteurs adaptés à fournir un confinement quantique dans au moins une direction de l'espace.

8. Dispositif optoélectronique selon la revendication 7, dans lequel les luminophores comprennent des boîtes quantiques.

9. Dispositif optoélectronique selon l'une quelconque des revendications 1 à 7, dans lequel la couche de protection (40) comprend un cristal monocristallin d'un luminophore.

10. Dispositif optoélectronique selon l'une quelconque des revendications 1 à 9, comprenant, en outre, une plaque (62) d'un matériau au moins en partie transparent au moins dans la gamme de longueur d'onde d'émission des diodes électroluminescentes et des éventuels luminophores, recouvrant la couche de protection (40) et reliée mécaniquement au substrat (12) .

11. Dispositif optoélectronique selon la revendication 10, dans lequel la plaque (62) est séparée de la couche de protection (40) par un film d'air ou de vide partiel.

12. Dispositif optoélectronique selon la revendication 10 ou 11, comprenant, en outre, des murs supplémentaires (42') dont la hauteur est supérieure à l'épaisseur de la couche de protection (40) au contact de la plaque (62) et reposant sur le substrat (12).

13. Dispositif optoélectronique selon l'une quelconque des revendications 1 à 12, comprenant, en outre, une couche conductrice (38) recouvrant la couche d'électrode (36) autour des diodes électroluminescentes de chaque ensemble.

14. Dispositif optoélectronique selon l'une quelconque des revendications 1 à 13, dans lequel le substrat (12) est en silicium, en germanium, en carbure de silicium, en un composé III-V, tel que du GaN ou du GaAs, ou en ZnO.

15. Dispositif optoélectronique selon l'une quelconque des revendications 1 à 14, dans lequel chaque élément semiconducteur (26) est majoritairement en un composé III-V, notamment du nitrure de gallium, ou en un composé II-VI.

16. Dispositif optoélectronique selon l'une quelconque des revendications 1 à 15, dans lequel le dispositif optoélectronique est un écran d'affichage ou un dispositif de projection.

17. Dispositif optoélectronique selon l'une quelconque des revendications 1 à 16, comprenant, en outre, sur la couche de protection (40) des filtres (53) adaptés à absorber et/ou réfléchir au moins en partie le rayonnement émis par les diodes électroluminescentes.

18. Dispositif optoélectronique selon la revendication 10, comprenant, en outre, sur la plaque (62) des filtres (66) adaptés à absorber et/ou réfléchir au moins en partie le rayonnement émis par les diodes électroluminescentes.

19. Dispositif optoélectronique selon l'une quelconque des revendications 1 à 18, dans lequel les murs (128) correspondent à des portions du substrat (12).

20. Procédé de fabrication d'un dispositif optoélectronique (10) comprenant les étapes suivantes :
a) former, dans un substrat (12) comprenant des première et deuxième faces opposées (14, 16), des éléments (18) d'isolation électrique latérale s'étendant de la première face (16) à la deuxième face (14) et délimitant dans le substrat des premières portions semiconductrices ou conductrices (20) isolées électriquement les unes des autres ;
b) former, pour chaque première portion, un ensemble (D) de diodes électroluminescentes reposant sur la première face et reliées électriquement à la première portion, chaque diode électroluminescente comprenant au moins un élément semiconducteur (26) filaire, conique ou tronconique, intégrant ou recouvert au sommet et/ou au moins sur une partie de ses faces latérales par une coque (34) comprenant au moins une couche active adaptée à fournir la majorité du rayonnement de la diode électroluminescente ;
c) former, pour chaque première portion, une couche d'électrode (36) conductrice et au moins partiellement transparente au moins dans la gamme de longueur d'onde d'émission des diodes électroluminescentes recouvrant toutes les diodes électroluminescentes ;
d) former une couche de protection (40 ; 72 ; 106) d'un premier matériau diélectrique et au moins partiellement transparent au moins dans la gamme de longueur d'onde d'émission des diodes électroluminescentes et d'éventuels luminophores présents dans la couche de protection, et des murs (42 ; 74 ; 110 ; 128) s'étendant au moins en partie dans la couche de protection et délimitant dans la couche de protection des deuxièmes portions entourant ou en vis-à-vis des ensembles (D) de diodes électroluminescentes, les murs contenant au moins un deuxième matériau différent du premier matériau et compris dans le groupe comprenant l'air, un métal, un matériau semiconducteur, un alliage métallique, un matériau partiellement transparent au moins dans la gamme de longueur d'onde d'émission des diodes électroluminescentes et des éventuels luminophores et un coeur en un matériau au moins partiellement transparent au moins dans la gamme de longueur d'onde d'émission des diodes électroluminescentes et des éventuels luminophores recouvert d'une couche opaque ou réfléchissante au moins dans la gamme de longueur d'onde d'émission des diodes électroluminescentes et des éventuels luminophores.

21. Procédé selon la revendication 20, dans lequel la couche de protection (40) entoure chaque diode électroluminescente.

22. Procédé selon la revendication 20, dans lequel la couche de protection (72 ; 106) n'entoure pas les diodes électroluminescentes.

23. Procédé selon l'une quelconque des revendications 20 à 22, dans lequel les murs (42 ; 74) s'étendent au moins sur la totalité de l'épaisseur de la couche de protection (40 ; 72).

24. Procédé selon l'une quelconque des revendications 20 à 23, dans lequel au moins l'un des murs (42) comprend un bloc (43) solide se prolongeant par une ouverture (58) remplie d'air.

25. Procédé selon l'une quelconque des revendications 20 à 24, dans lequel la couche de protection (40) comprend des luminophores.

26. Procédé selon la revendication 25, dans lequel les luminophores comprennent des matériaux semiconducteurs adaptés à fournir un confinement quantique dans au moins une direction de l'espace.

27. Procédé selon la revendication 26, dans lequel les luminophores comprennent des boîtes quantiques.

28. Procédé selon l'une quelconque des revendications 20 à 26, dans lequel la couche de protection (40) comprend un cristal monocristallin d'un luminophore.

29. Procédé selon l'une quelconque des revendications 20 à 28, comprenant, en outre, la liaison mécanique au substrat (12) d'une plaque (62) d'un matériau au moins en partie transparent au moins dans la gamme de longueur d'onde d'émission des diodes électroluminescentes et des éventuels luminophores et recouvrant la couche de protection (40).

30. Procédé selon la revendication 29, dans lequel la plaque (62) est séparée de la couche de protection (40) par un film d'air ou de vide partiel.

31. Procédé selon la revendication 29 ou 30, comprenant, en outre, la formation de murs supplémentaires (42') dont la hauteur est supérieure à l'épaisseur de la couche de protection (40) au contact de la plaque (62) et reposant sur le substrat (12) .

32. Procédé selon l'une quelconque des revendications 20 à 31, comprenant, en outre, la formation d'une couche conductrice (38) recouvrant la couche d'électrode (36) autour des diodes électroluminescentes de chaque ensemble.

33. Procédé selon l'une quelconque des revendications 20 à 32, dans lequel le substrat (12) est en silicium, en germanium, en carbure de silicium, en un composé III-V, tel que du GaN ou du GaAs, ou en ZnO.

34. Procédé selon l'une quelconque des revendications 20 à 33, dans lequel chaque élément semiconducteur (26) est majoritairement en un composé III-V, notamment du nitrure de gallium, ou en un composé II-VI.

35. Procédé selon l'une quelconque des revendications 20 à 34, dans lequel le dispositif optoélectronique est un écran d'affichage ou un dispositif de projection.

36. Procédé selon l'une quelconque des revendications 20 à 35, comprenant, en outre, la formation sur la couche de protection (40) de filtres (53) adaptés à absorber et/ou réfléchir au moins en partie le rayonnement émis par les diodes électroluminescentes.

37. Procédé selon la revendication 29, comprenant, en outre, la formation sur la plaque (62) de filtres (66) adaptés à absorber et/ou réfléchir au moins en partie le rayonnement émis par les diodes électroluminescentes.

38. Procédé selon l'une quelconque des revendications 20 à 37, dans lequel les murs (128) correspondent à des portions du substrat (12).

## Patentansprüche

1. Eine optoelektronische Einrichtung (10), die Folgendes aufweist:
ein Substrat (12) mit einer ersten und einer zweiten Oberfläche (14, 16), die einander gegenüberliegen, seitliche elektrische Isolierelemente (18), die sich von der ersten Oberfläche (16) zur zweiten Oberfläche (14) erstrecken und in dem Substrat erste Halbleiter- oder leitende Abschnitte (20) begrenzen, die elektrisch voneinander isoliert sind,
wobei die optoelektronische Einrichtung außerdem für jeden ersten Abschnitt eine Anordnung (D) von Leuchtdioden aufweist, die auf der ersten Oberfläche ruht und elektrisch mit dem ersten Abschnitt gekoppelt ist, wobei jede Leuchtdiode mindestens ein drahtförmiges, konisches oder verjüngtes Halbleiterelement (26) aufweist, das an der Oberseite und/oder mindestens auf einem Abschnitt seiner Seitenflächen mit einer Hülle (34) integriert oder bedeckt ist, die mindestens eine aktive Schicht aufweist, die in der Lage ist, den größten Teil der Strahlung der Leuchtdiode zu liefern,
wobei die optoelektronische Einrichtung ferner eine leitende Elektrodenschicht (36), die zumindest teilweise transparent zumindest in dem Emissionswellenlängenbereich der lichtemittierenden Dioden ist und alle lichtemittierenden Dioden abdeckt, eine Schutzschicht (40; 72; 106), die ein erstes dielektrisches Material enthält, das zumindest teilweise transparent zumindest in dem Emissionswellenlängenbereich der lichtemittierenden Dioden und mögliche Luminophore, die in der Schutzschicht vorhanden sind, ist, und Wände (42; 74; 110; 128) aufweist, die sich zumindest teilweise in der Schutzschicht erstrecken und in der Schutzschicht zweite Abschnitte abgrenzen, die die Anordnungen (D) von Leuchtdioden umgeben oder diesen gegenüberliegen, wobei die Wände mindestens ein zweites Material enthalten, das sich von dem ersten Material unterscheidet und zu der Gruppe gehört, die Luft, ein Metall, ein Halbleitermaterial und eine Metalllegierung aufweist, einem Material, das zumindest in der Emissionswellenlänge der Leuchtdioden und der möglichen Luminophore teilweise transparent ist, und einem Kern aus einem Material, das zumindest in dem Emissionswellenlängenbereich der Leuchtdioden und der möglichen Luminophore zumindest teilweise transparent ist und mit einer Schicht bedeckt ist, die zumindest in dem Emissionswellenlängenbereich der Leuchtdioden und der möglichen Luminophore opak oder reflektierend ist.

2. Optoelektronische Einrichtung nach Anspruch 1, bei die Schutzschicht (40) jede Leuchtdiode umgibt.

3. Optoelektronische Einrichtung nach Anspruch 1 oder 2, wobei die Schutzschicht (72; 106) die Leuchtdioden nicht umgibt.

4. Optoelektronische Einrichtung nach einem der Ansprüche 1 bis 3, wobei sich die Wände (42; 74) mindestens über die gesamte Dicke der Schutzschicht (40; 72) erstrecken.

5. Optoelektronische Einrichtung nach einem der Ansprüche 1 bis 4, wobei mindestens eine der Wände (42) einen massiven Block (43) aufweist, der sich durch eine mit Luft gefüllte Öffnung (58) fortsetzt.

6. Optoelektronische Einrichtung nach einem der Ansprüche 1 bis 5, wobei die Schutzschicht (40) Luminophore enthält.

7. Optoelektronische Einrichtung nach Anspruch 6, wobei die Luminophore Halbleitermaterialien aufweisen, die geeignet sind, eine Quanteneinschließung in mindestens einer Raumrichtung zu schaffen.

8. Optoelektronische Einrichtung nach Anspruch 7, wobei die Luminophore Quantenpunkte aufweisen.

9. Optoelektronische Einrichtung nach einem der Ansprüche 1 bis 7, wobei die Schutzschicht (40) einen Einkristall eines Luminophors aufweist.

10. Optoelektronische Einrichtung nach einem der Ansprüche 1 bis 9, die weiterhin eine Platte (62) aus einem Material aufweist, das zumindest teilweise transparent ist, zumindest im Emissionswellenlängenbereich der lichtemittierenden Dioden und der möglichen Luminophore, die die Schutzschicht (40) bedeckt und mechanisch mit dem Substrat (12) gekoppelt ist.

11. Optoelektronische Einrichtung nach Anspruch 10, wobei die Platte (62) durch einen Luft- oder Teilvakuumfilm von der Schutzschicht (40) getrennt ist.

12. Optoelektronische Einrichtung nach Anspruch 10 oder 11, die ferner zusätzliche Wände (42') aufweist, deren Höhe größer ist als die Dicke der Schutzschicht (40), die in Kontakt mit der Platte (62) steht und auf dem Substrat (12) aufliegt.

13. Optoelektronische Einrichtung nach einem der Ansprüche 1 bis 12, ferner mit einer leitenden Schicht (38), die die Elektrodenschicht (36) um die lichtemittierenden Dioden jeder Anordnung herum bedeckt.

14. Optoelektronische Einrichtung nach einem der Ansprüche 1 bis 13, wobei das Substrat (12) aus Silizium, Germanium, Siliziumkarbid, einer III-V-Verbindung, wie GaN oder GaAs, oder aus ZnO hergestellt ist.

15. Optoelektronische Einrichtung nach einem der Ansprüche 1 bis 14, wobei jedes Halbleiterelement (26) überwiegend aus einer III-V-Verbindung, insbesondere Galliumnitrid, oder aus einer II-VI-Verbindung besteht.

16. Optoelektronische Einrichtung nach einem der Ansprüche 1 bis 15, wobei die optoelektronische Einrichtung ein Bildschirm oder eine Projektionseinrichtung ist.

17. Die optoelektronische Einrichtung nach einem der Ansprüche 1 bis 16, die ferner auf der Schutzschicht (40) Filter (53) aufweist, die in der Lage sind, die von den Leuchtdioden emittierte Strahlung zumindest teilweise zu absorbieren und/oder zu reflektieren.

18. Optoelektronische Einrichtung nach Anspruch 10, die ferner auf der Platte (62) Filter (66) aufweist, die in der Lage sind, die von den Leuchtdioden emittierte Strahlung zumindest teilweise zu absorbieren und/oder zu reflektieren.

19. Optoelektronische Einrichtung nach einem der Ansprüche 1 bis 18, wobei die Wände (128) Teilen des Substrats (12) entsprechen.

20. Ein Verfahren zur Herstellung einer optoelektronischen Einrichtung (10), wobei das Verfahren die folgenden Schritte aufweist:
a) in einem Substrat (12), das erste und zweite gegenüberliegende Oberflächen (14, 16) aufweist, seitliche elektrische Isolierelemente (18) auszubilden, die sich von der ersten Oberfläche (16) zur zweiten Oberfläche (14) erstrecken und in dem Substrat erste Halbleiter- oder leitende Abschnitte (20) begrenzen, die elektrisch voneinander isoliert sind;
b) Bilden für jeden ersten Abschnitt, eine Anordnung (D) von Leuchtdioden, die auf der ersten Oberfläche ruht und mit dem ersten Abschnitt elektrisch gekoppelt ist, wobei jede Leuchtdiode mindestens ein drahtförmiges, konisches oder verjüngtes Halbleiterelement (26) aufweist, das an der Oberseite und/oder mindestens auf einem Abschnitt seiner Seitenflächen mit einer Hülle (34) integriert oder bedeckt ist, die mindestens eine aktive Schicht aufweist, die in der Lage ist, den größten Teil der Strahlung der Leuchtdiode zu liefern;
c) Bilden, für jeden ersten Abschnitt, einer leitfähigen elektrischen Leiterschicht (36), die zumindest teilweise transparent ist, zumindest in dem Emissionswellenlängenbereich der Leuchtdioden, der alle Leuchtdioden abdeckt;
d) Bilden einer Schutzschicht (40; 72; 106) aus einem ersten dielektrischen Material, das zumindest teilweise transparent ist zumindest in dem Emissionswellenlängenbereich der lichtemittierenden Dioden und von möglichen Luminophoren, die in der die Elektrodenschicht bedeckenden Schutzschicht vorhanden sind, und Wänden (42; 74; 110; 128), die sich zumindest teilweise in der Schutzschicht erstrecken und in der Schutzschicht zweite Abschnitte abgrenzen, die die Anordnungen (D) von Leuchtdioden umgeben oder diesen gegenüberliegen, wobei die Wände mindestens ein zweites Material enthalten, das sich von dem ersten Material unterscheidet und zu der Gruppe gehört, die Luft, ein Metall, eine Metalllegierung aufweist, einem Material, das zumindest in der Emissionswellenlänge der Leuchtdioden und der möglichen Luminophore teilweise transparent ist, und einem Kern aus einem Material, das zumindest in dem Emissionswellenlängenbereich der Leuchtdioden und der möglichen Luminophore zumindest teilweise transparent ist und mit einer Schicht bedeckt ist, die zumindest in dem Emissionswellenlängenbereich der Leuchtdioden und der möglichen Luminophore opak oder reflektierend ist.

21. Verfahren nach Anspruch 20, wobei die Schutzschicht (40) jede Leuchtdiode umgibt.

22. Verfahren nach Anspruch 20, wobei die Schutzschicht (72; 106) die Leuchtdioden nicht umgibt.

23. Verfahren nach einem der Ansprüche 20 bis 22, bei dem sich die Wände (42; 74) mindestens über die gesamte Dicke der Schutzschicht (40; 72) erstrecken.

24. Verfahren nach einem der Ansprüche 20 bis 23, wobei mindestens eine der Wände (42) einen massiven Block (43) aufweist, der durch eine mit Luft gefüllte Öffnung (58) fortgesetzt wird.

25. Verfahren nach einem der Ansprüche 20 bis 24, bei dem die Schutzschicht (40) aus Luminophoren besteht.

26. Verfahren nach Anspruch 25, wobei die Luminophore Halbleitermaterialien aufweisen, die geeignet sind, eine Quanteneinschließung in mindestens einer Raumrichtung zu schaffen.

27. Verfahren nach Anspruch 26, wobei die Luminophore Quantenpunkte aufweisen.

28. Verfahren nach einem der Ansprüche 20 bis 26, wobei die Schutzschicht (40) einen Einkristall eines Luminophors aufweist.

29. Verfahren nach einem der Ansprüche 20 bis 28, das weiterhin die mechanische Kopplung einer Platte (62) aus einem Material, das zumindest teilweise zumindest im Emissionswellenlängenbereich der Leuchtdioden und der möglichen Luminophore transparent ist und die Schutzschicht (40) bedeckt, an das Substrat (12) aufweist.

30. Verfahren nach Anspruch 29, wobei die Platte (62) durch einen Luft- oder Teilvakuumfilm von der Schutzschicht (40) getrennt wird.

31. Verfahren nach Anspruch 29 oder 30, das ferner die Bildung zusätzlicher Wände (42') mit einer Höhe, die größer ist als die Dicke der Schutzschicht (40), die in Kontakt mit der Platte (62) steht und auf dem Substrat (12) ruht, aufweist.

32. Verfahren nach einem der Ansprüche 20 bis 31, das ferner die Bildung einer leitenden Schicht (38) aufweist, die die Elektrodenschicht (36) um die lichtemittierenden Dioden jeder Anordnung herum bedeckt.

33. Verfahren nach einem der Ansprüche 20 bis 32, wobei das Substrat (12) aus Silicium, Germanium, Siliciumcarbid, einer III-V-Verbindung, wie GaN oder GaAs, oder aus ZnO hergestellt wird.

34. Verfahren nach einem der Ansprüche 20 bis 33, wobei jedes Halbleiterelement (26) überwiegend aus einer III-V-Verbindung, insbesondere Galliumnitrid, oder aus einer II-VI-Verbindung hergestellt ist.

35. Verfahren nach einem der Ansprüche 20 bis 34, bei dem die optoelektronische Einrichtung ein Bildschirm oder eine Projektionseinrichtung ist.

36. Verfahren nach einem der Ansprüche 20 bis 35, das ferner die Bildung von Filtern (53) auf der Schutzschicht (40) aufweist, die in der Lage sind, die von den Leuchtdioden emittierte Strahlung zumindest teilweise zu absorbieren und/oder zu reflektieren.

37. Verfahren nach Anspruch 29, das ferner das Ausbilden von Filtern (66) auf der Platte (62), die in der Lage sind, die von den Leuchtdioden emittierte Strahlung zumindest teilweise zu absorbieren und/oder zu reflektieren, aufweist.

38. Verfahren nach einem der Ansprüche 20 bis 37, wobei die Wände (128) Teilen des Substrats (12) entsprechen.

## Claims

1. An optoelectronic device (10) comprising:
a substrate (12) comprising first and second opposite surfaces (14, 16), lateral electrical insulation elements (18) extending from the first surface (16) to the second surface (14) and delimiting in the substrate first semiconductor or conductive portions (20) electrically insulated from one another,
the optoelectronic device further comprising, for each first portion, an assembly (D) of light-emitting diodes resting on the first surface and electrically coupled to the first portion, each light-emitting diode comprising at least one wire-shaped, conical, or tapered semiconductor element (26) integrating or covered at the top and/or at least on a portion of its lateral surfaces with a shell (34) comprising at least one active layer capable of supplying most of the radiation of the light-emitting diode,
the optoelectronic device further comprising a conductive electrode layer (36) at least partially transparent at least in the emission wavelength range of the light-emitting diodes covering all the light-emitting diodes, a protection layer (40; 72; 106) containing a first dielectric material at least partially transparent at least in the emission wavelength range of the light-emitting diodes and possible luminophores present in the protection layer, and walls (42; 74; 110; 128) at least partly extending in the protection layer and delimiting in the protection layer second portions surrounding or opposite the assemblies (D) of light-emitting diodes, the walls containing at least one second material different from the first material and comprised in the group comprising air, a metal, a semiconductor material, a metal alloy, a material partially transparent at least in the emission wavelength of the light-emitting diodes and of the possible luminophores, and a core made of a material at least partially transparent at least in the emission wavelength range of the light-emitting diodes and of the possible luminophores covered with a layer which is opaque or reflective at least in the emission wavelength range of the light-emitting diodes and of the possible luminophores.

2. The optoelectronic device of claim 1, wherein the protection layer (40) surrounds each light-emitting diode.

3. The optoelectronic device of claim 1 or 2, wherein the protection layer (72; 106) does not surround the light-emitting diodes.

4. The optoelectronic device of any of claims 1 to 3, wherein the walls (42; 74) extend at least across the entire thickness of the protection layer (40; 72).

5. The optoelectronic device of any of claims 1 to 4, wherein at least one of the walls (42) comprises a solid block (43) continued by an opening (58) filled with air.

6. The optoelectronic device of any of claims 1 to 5, wherein the protection layer (40) comprises luminophores.

7. The optoelectronic device of claim 6, wherein the luminophores comprise semiconductor materials adapted to provide a quantum confinement in at least one direction of space.

8. The optoelectronic device of claim 7, wherein luminophores comprise quantum dots.

9. The optoelectronic device of any of claims 1 to 7, wherein the protection layer (40) comprises a single crystal of a luminophore.

10. The optoelectronic device of any of claims 1 to 9, further comprising a plate (62) of a material at least partly transparent at least in the emission wavelength range of the light-emitting diodes and of the possible luminophores, covering the protection layer (40) and mechanically coupled to the substrate (12).

11. The optoelectronic device of claim 10, wherein the plate (62) is separated from the protection layer (40) by an air or partial vacuum film.

12. The optoelectronic device of claim 10 or 11, further comprising additional walls (42') having a height greater than the thickness of the protection layer (40) in contact with the plate (62) and resting on the substrate (12).

13. The optoelectronic device of any of claims 1 to 12, further comprising a conductive layer (38) covering the electrode layer (36) around the light-emitting diodes of each assembly.

14. The optoelectronic device of any of claims 1 to 13, wherein the substrate (12) is made of silicon, of germanium, of silicon carbide, of a III-V compound, such as GaN or GaAs, or of ZnO.

15. The optoelectronic device of any of claims 1 to 14, wherein each semiconductor element (26) is mostly made of a III-V compound, particularly gallium nitride, or of a II-VI compound.

16. The optoelectronic device of any of claims 1 to 15, wherein the optoelectronic device is a display screen or a projection device.

17. The optoelectronic device of any of claims 1 to 16, further comprising, on the protection layer (40), filters (53) capable of at least partly absorbing and/or of reflecting the radiation emitted by the light-emitting diodes.

18. The optoelectronic device of claim 10, further comprising, on the plate (62), filters (66) capable of at least partly absorbing and/or of reflecting the radiation emitted by the light-emitting diodes.

19. The optoelectronic device of any of claims 1 to 18, wherein the walls (128) correspond to portions of the substrate (12) .

20. A method of manufacturing an optoelectronic device (10), comprising the steps of:
a) forming, in a substrate (12) including first and second opposite surfaces (14, 16), lateral electrical insulation elements (18) extending from the first surface (16) to the second surface (14) and delimiting in the substrate first semiconductor or conductive portions (20) electrically insulated from one another;
b) forming, for each first portion, an assembly (D) of light-emitting diodes resting on the first surface and electrically coupled to the first portion, each light-emitting diode comprising at least one wire-shaped, conical, or tapered semiconductor element (26) integrating or covered at the top and/or at least on a portion of its lateral surfaces with a shell (34) comprising at least one active layer capable of supplying most of the radiation of the light-emitting diode;
c) forming, for each first portion, a conductive electrode layer (36) at least partially transparent at least in the emission wavelength range of the light-emitting diodes covering all the light-emitting diodes;
d) forming a protection layer (40; 72; 106) of a first dielectric material at least partially transparent at least in the emission wavelength range of the light-emitting diodes and of possible luminophores present in the protection layer covering the electrode layer, and walls (42; 74; 110; 128) at least partly extending in the protection layer and delimiting in the protection layer second portions surrounding or opposite the assemblies (D) of light-emitting diodes, the walls containing at least one second material different from the first material and comprised in the group comprising air, a metal, a metal alloy, a material partially transparent at least in the emission wavelength of the light-emitting diodes and of the possible luminophores, and a core made of a material at least partially transparent at least in the emission wavelength range of the light-emitting diodes and of the possible luminophores covered with a layer which is opaque or reflective at least in the emission wavelength range of the light-emitting diodes and of the possible luminophores.

21. The method of claim 20, wherein the protection layer (40) surrounds each light-emitting diode.

22. The method of claim 20, wherein the protection layer (72; 106) does not surround the light-emitting diodes.

23. The method of any of claims 20 to 22, wherein the walls (42; 74) extend at least across the entire thickness of the protection layer (40; 72).

24. The method of any of claims 20 to 23, wherein at least one of the walls (42) comprises a solid block (43) continued by an opening (58) filled with air.

25. The method of any of claims 20 to 24, wherein the protection layer (40) comprises luminophores.

26. The method of claim 25, wherein the luminophores comprise semiconductor materials adapted to provide a quantum confinement in at least one direction of space.

27. The method of claim 26, wherein luminophores comprise quantum dots.

28. The method of any of claims 20 to 26, wherein the protection layer (40) comprises a single crystal of a luminophore.

29. The method of any of claims 20 to 28, further comprising the mechanical coupling to the substrate (12) of a plate (62) of a material at least partly transparent at least in the emission wavelength range of the light-emitting diodes and of the possible luminophores and covering the protection layer (40).

30. The method of claim 29, wherein the plate (62) is separated from the protection layer (40) by an air or partial vacuum film.

31. The method of claim 29 or 30, further comprising the forming of additional walls (42') having a height greater than the thickness of the protection layer (40) in contact with the plate (62) and resting on the substrate (12).

32. The method of any of claims 20 to 31, further comprising the forming of a conductive layer (38) covering the electrode layer (36) around the light-emitting diodes of each assembly.

33. The method of any of claims 20 to 32, wherein the substrate (12) is made of silicon, of germanium, of silicon carbide, of a III-V compound, such as GaN or GaAs, or of ZnO.

34. The method of any of claims 20 to 33, wherein each semiconductor element (26) is mostly made of a III-V compound, particularly gallium nitride, or of a II-VI compound.

35. The method of any of claims 20 to 34, wherein the optoelectronic device is a display screen or a projection device.

36. The method of any of claims 20 to 35, further comprising the forming on the protection layer (40) of filters (53) capable of at least partly absorbing and/or of reflecting the radiation emitted by the light-emitting diodes.

37. The method of claim 29, further comprising the forming on the plate (62) of filters (66) capable of at least partly absorbing and/or of reflecting the radiation emitted by the light-emitting diodes.

38. The method of any of claims 20 to 37, wherein the walls (128) correspond to portions of the substrate (12).
